# EUROPEAN PATENT APPLICATION

(11) **EP 4 657 203 A1**
(43) Date of publication of application: **03.12.2025**
(21) Application number: 24792801.3
(22) Date of filing: 05.02.2024
(51) Int. Cl.: G06F 1/20, G06F 1/16

(54) **FLEXIBLE DISPLAY AND ELECTRONIC DEVICE COMPRISING SAME**

(30) Priority: 17.04.2023 KR 20230050267; 09.05.2023 KR 20230059750
(71) Applicant: Samsung Electronics Co., Ltd., Suwon-si, Gyeonggi-do 16677 (KR)
(72) Inventor: BAE, Jaehyun, Suwon-si, Gyeonggi-do 16677 (KR); KIM, Taejeong, Suwon-si, Gyeonggi-do 16677 (KR); MOON, Youngmin, Suwon-si, Gyeonggi-do 16677 (KR); PARK, Byounggyu, Suwon-si, Gyeonggi-do 16677 (KR); SONG, Kyunghwan, Suwon-si, Gyeonggi-do 16677 (KR); YOO, Areum, Suwon-si, Gyeonggi-do 16677 (KR); CHOI, Hyunsuk, Suwon-si, Gyeonggi-do 16677 (KR)
(74) Representative: Gulde & Partner
(86) International application number: PCT/KR2024/001643
(87) International publication number: WO 2024/219613

(57) **Abstract**

An electronic device according to an embodiment of the present disclosure may comprise: a first housing; a second housing coupled to the first housing so as to be movable in one direction with respect to the latter; at least one heating element disposed in the first housing or second housing; and a display assembly which is disposed across the first and second housings and at least a part of which is bendable, the display assembly comprising: a display panel; a support plate disposed below the display panel and having a plurality of space parts formed thereon; a first heat dissipation member disposed between the display panel and support plate; and a second heat dissipation member filled in the plurality of space parts.

## Description

### [Technical Field]

Various embodiments of the disclosure relate to a flexible display and an electronic device including the same.

### [Background Art]

Recently, there is increasing interest in bendable electronic devices (also referred to as 'flexible electronic devices') including a bendable flexible display (simply 'flexible display'). Flexible electronic devices may include, e.g., slidable electronic devices, foldable electronic devices, or rollable electronic devices.

Components that generate heat, such as a circuit board or a battery, may be disposed in the inner space of the electronic device. The electronic device may provide a heat dissipation structure for dissipating heat generated internally to the outside.

The above-described information may be provided as related art for the purpose of helping understanding of the disclosure. No claim or determination is made as to whether any of the foregoing is applicable as background art in relation to the disclosure.

### [Disclosure of Invention]

### [Solution to Problems]

Various embodiments of the disclosure may dissipate heat generated by a heat generating element to the outside using a heat dissipation member disposed on at least one of the upper or lower portion of a support plate that supports a flexible display, and a heat dissipation member filling space portions formed to ensure stretchability of the support plate.

An electronic device according to an embodiment of the disclosure may comprise a first housing, a second housing coupled to the first housing to be movable with respect to the first housing, at least one heat generating element disposed in the first housing or the second housing, a display assembly disposed across the first housing and the second housing and configured so that at least a portion thereof is bendable, the display assembly comprising a display panel, a support plate disposed under the display panel and having a plurality of space portions formed therein, a first heat dissipation member disposed between the display panel and the support plate, and a second heat dissipation member filling the plurality of space portions, and a third heat dissipation member disposed between at least one of the first heat dissipation member and the support plate and the at least one heat generating element.

According to an embodiment of the disclosure, a display assembly configured so that at least a portion thereof is bendable may comprise a display panel, a support plate disposed under the display panel and having a plurality of space portions formed therein, a first heat dissipation member disposed between the display panel and the support plate, and a second heat dissipation member filling the plurality of space portions of the support plate.

According to various embodiments proposed in the disclosure, the electronic device may provide a heat dissipation structure with enhanced heat dissipation efficiency by efficiently using the limited inner space of the electronic device.

Effects achievable in example embodiments of the disclosure are not limited to the above-mentioned effects, but other effects not mentioned may be apparently derived and understood by one of ordinary skill in the art to which example embodiments of the disclosure pertain, from the following description. In other words, unintended effects in practicing embodiments of the disclosure may also be derived by one of ordinary skill in the art from example embodiments of the disclosure.

### [Brief Description of Drawings]

FIG. 1 is a block diagram illustrating an electronic device in a network environment according to various embodiments.
FIG. 2A is a front view illustrating an electronic device in a first state according to an embodiment.
FIG. 2B is a rear view illustrating an electronic device in a first state according to an embodiment.
FIG. 3A is a front view illustrating an electronic device in a second state according to an embodiment.
FIG. 3B is a rear view illustrating an electronic device in a second state according to an embodiment.
FIG. 4 is an exploded perspective view illustrating an electronic device according to an embodiment.
FIG. 5A is a cross-sectional view illustrating an example of the electronic device according to an embodiment, taken along line A-A' of FIG. 2A.
FIG. 5B is a cross-sectional view illustrating an example of the electronic device according to an embodiment, taken along line B-B' of FIG. 3A.
FIG. 6 is an exploded perspective view illustrating a flexible display assembly according to an embodiment.
FIG. 7 is a cross-sectional view illustrating an example of the support plate according to an embodiment, taken along line C-C' of FIG. 6.
FIG. 8 is a cross-sectional view schematically illustrating a heat dissipation structure of an electronic device according to an embodiment.
FIG. 9 is a cross-sectional view schematically illustrating a heat dissipation process of an electronic device according to an embodiment.
FIG. 10 is a cross-sectional view schematically illustrating a heat dissipation structure with enhanced adhesion in an electronic device according to an embodiment.
FIG. 11 is an exploded perspective view illustrating a flexible display assembly according to an embodiment.
FIG. 12 is a cross-sectional view schematically illustrating a heat dissipation structure of an electronic device according to an embodiment.
FIG. 13 is a cross-sectional view schematically illustrating a heat dissipation process of an electronic device according to an embodiment.
FIG. 14 is a cross-sectional view schematically illustrating a heat dissipation structure with enhanced adhesion in an electronic device according to an embodiment.
FIG. 15 is a cross-sectional view schematically illustrating a heat dissipation structure of an electronic device according to an embodiment.
FIGS. 16A and 16B are views of an electronic device according to an embodiment, with some components omitted.
FIGS. 17A and 17B are plan views of an electronic device according to another embodiment, with some components omitted.
FIGS. 18A and 18B are plan views of an electronic device according to another embodiment, with some components omitted.

Reference may be made to the accompanying drawings in the following description, and specific examples that may be practiced are shown as examples within the drawings. Other examples may be utilized and structural changes may be made without departing from the scope of the various examples.

### [Mode for the Invention]

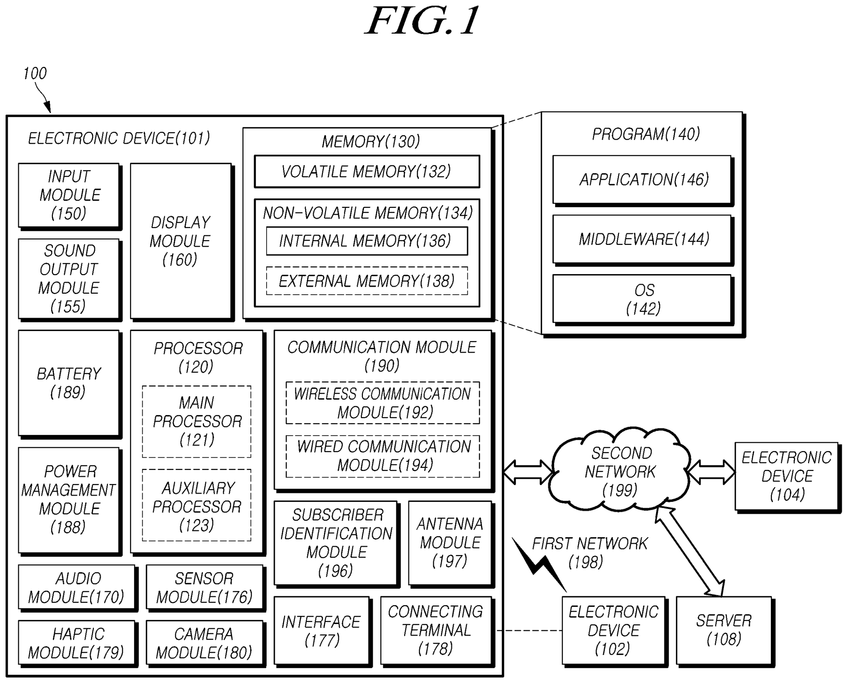

Various embodiments of the disclosure are merely exemplified herein with reference to FIGS. 1 to 18B, to describe the principle of the disclosure, and should not be interpreted as limiting the scope of the disclosure. Those skilled in the art will understand that the principle of the disclosure may be implemented in any appropriately disposed system or device.

Hereinafter, embodiments of the disclosure are described in detail with reference to the drawings so that those skilled in the art to which the disclosure pertains may easily practice the disclosure. However, the disclosure may be implemented in other various forms and is not limited to the embodiments set forth herein. The same or similar reference denotations may be used to refer to the same or similar elements throughout the specification and the drawings. Further, for clarity and brevity, no description is made of well-known functions and configurations in the drawings and relevant descriptions.

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, in a case where the electronic device 101 includes the main processor 121 and the sub processor 123, the sub processor 123 may be configured to use lower power than the main processor 121 or to be specified for a designated function. The sub processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or loT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

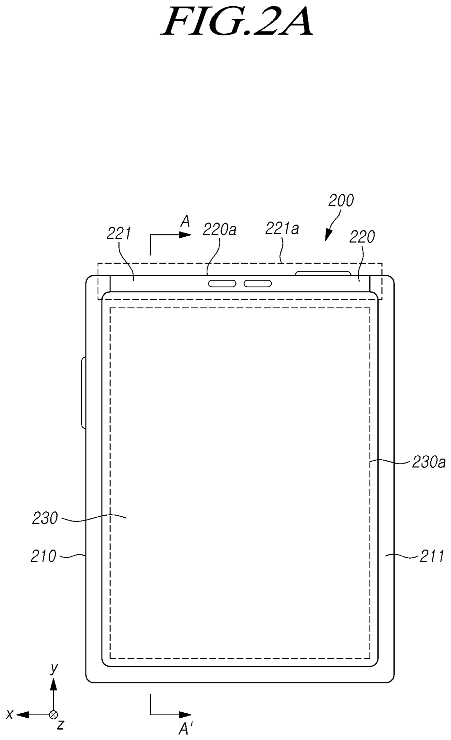

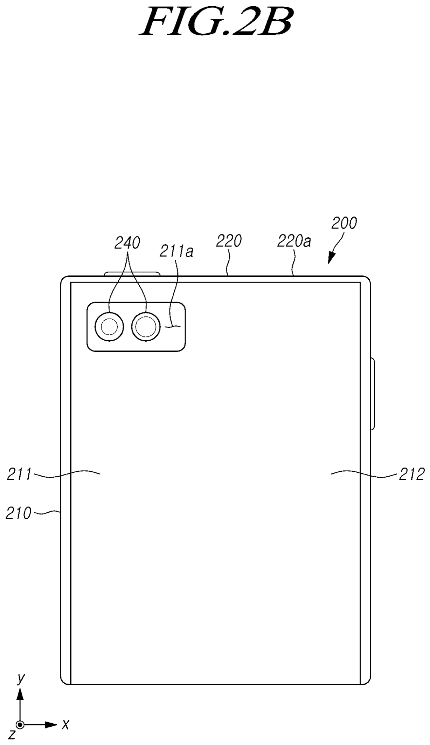

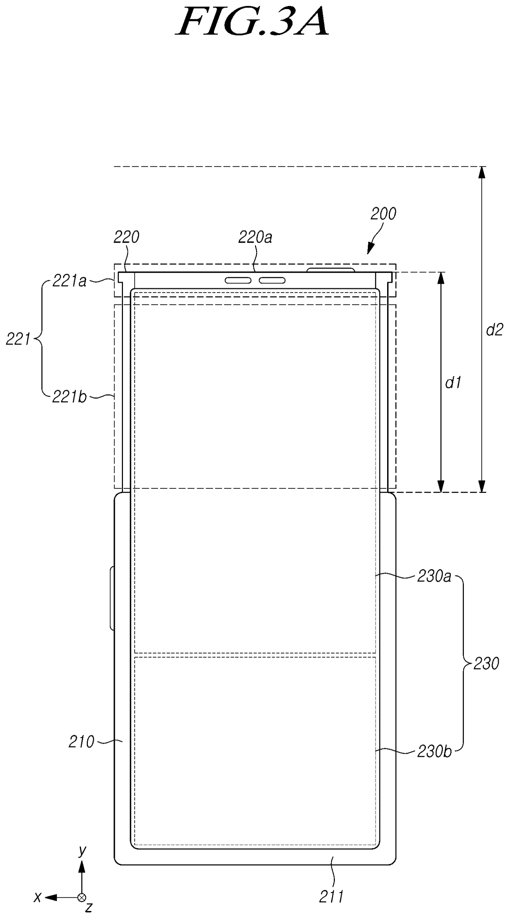

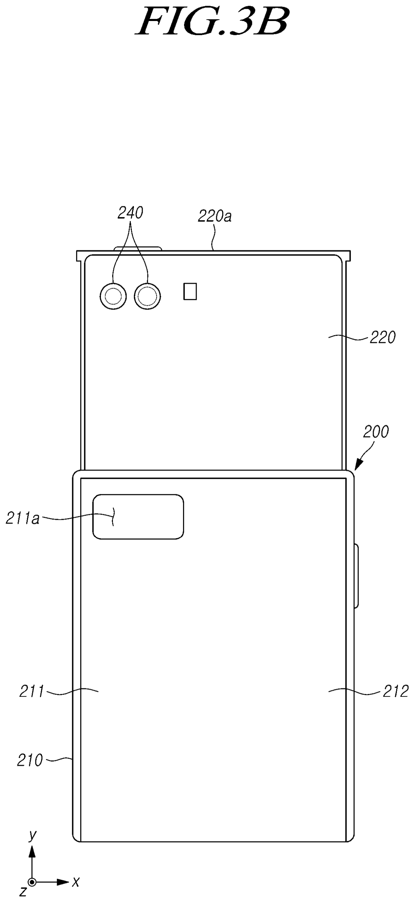

FIG. 2A is a front view illustrating an electronic device in a first state according to an embodiment. FIG. 2B is a rear view illustrating an electronic device in a first state according to an embodiment. FIG. 3A is a front view illustrating an electronic device in a second state according to an embodiment. FIG. 3B is a rear view illustrating an electronic device in a second state according to an embodiment.

Referring to FIGS. 2A, 2B, 3A, and 3B, an electronic device 200 (e.g., the electronic device 101 of FIG. 1) according to an embodiment may include a first housing 210, a second housing 220, a display 230 (e.g., the display module 160 of FIG. 1), and a camera 240 (e.g., the camera module 180 of FIG. 1). According to an embodiment, the second housing 220 may be slidable with respect to the first housing 210. For example, the second housing 220 may move with respect to the first housing 210 along a first direction (e.g., +y direction) in a range of a designated distance. In a case where the second housing 220 moves along the first direction, the distance between a side surface 220a of the second housing 220 facing the first direction and the first housing 210 may increase. As another example, the second housing 220 may move with respect to the first housing 210 along a second direction (e.g., -y direction) opposite to the first direction in a range of a designated distance. In a case where the second housing 220 moves along the second direction, the distance between the side surface 220a of the second housing 220 facing the first direction and the first housing 210 may decrease. According to an embodiment, the second housing 220 may perform linear reciprocating motion with respect to the first housing 210 by sliding relative to the first housing 210. For example, at least a portion of the second housing 220 may be retractable into the first housing 210 or extractable from the first housing 210.

According to an embodiment, the electronic device 200 may be referred to as a "slidable electronic device" as the second housing 220 is designed to be slidable with respect to the first housing 210. According to an embodiment, the electronic device 200 may be referred to as a "rollable electronic device" as at least a portion of the display 230 is designed to be rolled inside the second housing 220 (or first housing 210) based on the sliding movement of the second housing 220.

According to an embodiment, the first state of the electronic device 200 may be defined as a state in which the second housing 220 has moved in the second direction (e.g., contracted state, closed state, retracted state, or slide-in state). For example, in the first state of the electronic device 200, the second housing 220 may not be substantially movable in the second direction. In the first state of the electronic device 200, the distance between the side surface 220a of the second housing 220 and the first housing 210 may not be decreased. As another example, in the first state of the electronic device 200, a portion of the second housing 220 may not be retractable. According to an embodiment, the first state of the electronic device 200 may be a state in which a second area 230b of the display 230 is not visually exposed outside the electronic device 200. For example, in the first state of the electronic device 200, the second area 230b of the display 230 may be positioned inside an inner space (not illustrated) of the electronic device 200 formed by the first housing 210 and/or the second housing 220, and may not be visible from outside the electronic device 200.

According to an embodiment, the second state of the electronic device 200 may be defined as a state in which the second housing 220 has moved in the first direction (e.g., extracted state, open state, or slide-out state). For example, in the second state of the electronic device 200, the second housing 220 may not be substantially movable in the first direction. In the second state of the electronic device 200, the distance between the side surface 220a of the second housing 220 and the first housing 210 may not increase. As another example, in the second state of the electronic device 200, a portion of the second housing 220 may not be extractable from the first housing 210. According to an embodiment, the second state of the electronic device 200 may be a state in which the second area 230b of the display 230 is visually exposed outside the electronic device 200. For example, in the second state of the electronic device 200, the second area 230b of the display 230 may be extracted from the inner space of the electronic device 200 and be visible from outside the electronic device 200.

According to an embodiment, in a case where the second housing 220 moves from the first housing 210 in the first direction, at least a portion of the second housing 220 and/or the second area 230b of the display 230 may be extracted from the first housing 210 by an extraction length d1 corresponding to the moving distance of the second housing 220. According to an embodiment, the second housing 220 may reciprocate within a designated distance d2. According to an embodiment, the extraction length d1 may have a size of about 0 to a designated distance d2.

According to an embodiment, the state of the electronic device 200 may be convertible between the second state and/or the first state by manual operation by the user or by automatic operation by a driving module (not illustrated) disposed inside the first housing 210 or the second housing 220. According to an embodiment, the driving module may be triggered based on a user input. According to an embodiment, the user input for triggering the operation of the driving module may include a touch input, a force touch input, and/or a gesture input through the display 230. According to another embodiment, the user input for triggering the operation of the driving module may include a voice input or an input of a physical button exposed outside the first housing 210 or the second housing 220. According to an embodiment, the driving module may be driven in a semi-automatic manner where operation is triggered in a case where manual operation by external force from the user is detected.

According to an embodiment, the first state of the electronic device 200 may be referred to as a first shape, and the second state of the electronic device 200 may be referred to as a second shape. For example, the first shape may include a normal state, contracted state, or closed state, and the second shape may include an open state. According to an embodiment, the electronic device 200 may form a third state (e.g., intermediate state) that is between the first state and the second state. For example, the third state may be referred to as a third shape, and the third shape may include a free stop state.

According to an embodiment, the display 230 may be visible or viewable from outside through the front direction (e.g., -z direction) of the electronic device 200 to display visual information to the user. For example, the display 230 may include a flexible display (e.g., flexible display, extendable display, stretchable display, rollable display, or display assembly). According to an embodiment, at least a portion of the display 230 may be disposed on the second housing 220 and may be extracted from an inner space (not illustrated) of the electronic device 200 or retracted into the inner space of the electronic device 200 according to the movement of the second housing 220. The inner space of the electronic device 200 may refer to the space in the first housing 210 and the second housing 220 formed by the coupling of the first housing 210 and the second housing 220. For example, in the first state of the electronic device 200, at least a portion of the display 230 may be rolled and retracted into the inner space of the electronic device 200. If at least a portion of the display 230 is retracted into the inner space of the electronic device 200 and the second housing 220 moves in the first direction, at least a portion of the display 230 may be extracted from the inner space of the electronic device 200. As another example, in a case where the second housing 220 moves in the second direction, at least a portion of the display 230 may be retracted into the inner space of the electronic device 200 by rolling into the interior of the electronic device 200. As at least a portion of the display 230 is extracted or retracted, the area of the display 230 visible from outside the electronic device 200 may be extended or contracted. According to an embodiment, the display 230 may include a first area 230a and/or a second area 230b.

According to an embodiment, the first area 230a of the display 230 may refer to an area of the display 230 that is fixedly visible from outside the electronic device 200 regardless of whether the electronic device 200 is in the second state or the first state. For example, the first area 230a may refer to a partial area of the display 230 that does not roll into the inner space of the electronic device 200. According to an embodiment, the first area 230a may move together with the second housing 220 if the second housing 220 moves. For example, if the second housing 220 moves along the first direction or the second direction, the first area 230a may move along the first direction or the second direction on the front surface of the electronic device 200 together with the second housing 220.

According to an embodiment, the second area 230b of the display 230 may be retracted into the inner space of the electronic device 200 or extracted from the inner space of the electronic device 200 to the outside according to the movement of the second housing 220. For example, at least a portion of the second area 230b of the display 230 may be in a state retracted into the inner space of the electronic device 200 in a rolled state in the first state of the electronic device 200. The second area 230b of the display 230 may be retracted into the inner space of the electronic device 200 not to be visible from outside in the first state of the electronic device 200. As another example, the second area 230b of the display 230 may be in a state extracted from the inner space of the electronic device 200 in the second state of the electronic device 200. The second area 230b of the display 230 may be visible from outside the electronic device 200 in the second state.

According to an embodiment, in the first state of the electronic device 200, the area of the display 230 visible from outside the electronic device 200 may include only the first area 230a of the display 230. In the second state of the electronic device 200, the area of the display 230 visible from outside the electronic device 200 may include at least a portion of the first area 230a and the second area 230b of the display 230.

According to an embodiment, the first housing 210 of the electronic device 200 may include a first supporting member 211 surrounding the inner space of the first housing 210, a rear plate 212 covering the rear surface of the first supporting member 211, and a first side member 214 covering at least a portion of the edge of the first supporting member 211. According to an embodiment, the first supporting member 211 may be integrally formed with the first side member 214. The first supporting member 211 may extend from at least a portion of one surface of the first side member 214 facing the interior of the electronic device 200 into the interior of the electronic device 200. According to an embodiment, the first supporting member 211 and the first side member 214 may be integrally formed or formed of the same material.

According to an embodiment, the second housing 220 of the electronic device 200 may include a second supporting member 221 and a second side member 229 surrounding the inner space of the electronic device 200.

According to an embodiment, the second side member 229 may form at least a portion of the side surface of the second housing 220. The second supporting member 221 may support electronic components (e.g., the camera 240 and/or printed circuit board 224) disposed in the second housing 220. The second side member 229 may surround at least a portion of the second supporting member 221. According to an embodiment, the second supporting member 221 may be integrally formed with the second side member 229. The second supporting member 221 may extend from at least a portion of one surface of the second side member 229 facing the interior of the second housing 220 into the interior of the second housing 220. According to an embodiment, the second supporting member 221 and the second side member 229 may be integrally formed or formed of the same material.

According to an embodiment, the second supporting member 221 may include a first cover area 221a of the second supporting member 221 that is not inserted into the interior of the first housing 210, and a second cover area 221b that is inserted into or extracted from the interior of the first housing 210. The first cover area 221a of the second supporting member 221 may always be visible regardless of whether the electronic device 200 is in the second state or the first state. According to an embodiment, at least a portion of the first cover area 221a of the second supporting member 221 may form the side surface 220a of the second housing 220. According to an embodiment, the second cover area 221b of the second housing 220 may not be visible in the first state and may be visible in the second state.

The camera 240 may obtain an image of a subject based on receiving light from outside the electronic device 200. According to an embodiment, the camera 240 may include one or more lenses, an image sensor, and/or an image signal processor. According to an embodiment, the camera 240 may be disposed on the second housing 220 to face the rear surface of the electronic device 200 opposite to the front surface of the electronic device 200 where the first area 230a of the display 230 is disposed. For example, the camera 240 may be disposed on the second supporting member 221 of the second housing 220 and may be visible from outside the electronic device 200 through an opening 211a formed in the first supporting member 211 in a case where the electronic device 200 is in the first state. As another example, the camera 240 may be disposed on the second supporting member 221 of the second housing 220 and may not be visible from outside the electronic device 200 by being covered by the first supporting member 211 and/or the rear plate 212 in a case where the electronic device 200 is in the first state.

According to an embodiment, the camera 240 may include a plurality of cameras. For example, the camera 240 may include a wide-angle camera, ultra-wide-angle camera, telephoto camera, proximity camera, and/or depth camera. However, the camera 240 is not necessarily limited to including a plurality of cameras but may include one camera.

According to an embodiment, the camera 240 may further include a camera (not illustrated) facing the front surface of the electronic device 200 where the first area 230a of the display 230 is disposed. In a case where the camera 240 faces the front surface of the electronic device 200, the camera 240 may be an under display camera (UDC) disposed under the display 230 (e.g., in the +z direction from the display 230), but the disclosure is not limited thereto.

According to an embodiment, the electronic device 200 may include a sensor module (not illustrated) and/or a camera module (not illustrated) disposed under the display 230. The sensor module may detect the external environment based on information (e.g., light) received through the display 230. According to an embodiment, the sensor module may include at least one of a receiver, a proximity sensor, an ultrasonic sensor, a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, a motor encoder, or an indicator. According to an embodiment, at least some sensor modules of the electronic device 200 may be visually exposed from outside through a partial area of the display 230. According to an embodiment, the electronic device 200 may detect an extraction length (e.g., length d1) using the sensor module. According to an embodiment, the electronic device 200 may generate extraction information regarding the degree of extraction detected by the sensor. For example, the electronic device 200 may detect and/or identify the degree of extraction of the second housing 220 using the extraction information. According to an embodiment, the extraction information may include information regarding the extraction length of the second housing 220.

According to an embodiment, the coupling form of the first housing 210 and the second housing 220 is not limited to the form and coupling illustrated in FIGS. 2A, 2B, 3A, and 3B, and may be implemented by combinations and/or couplings of other shapes or components.

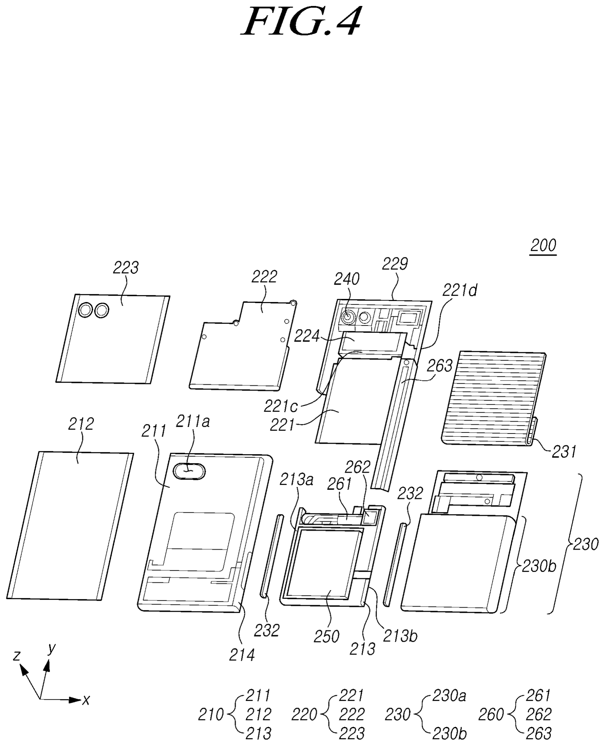

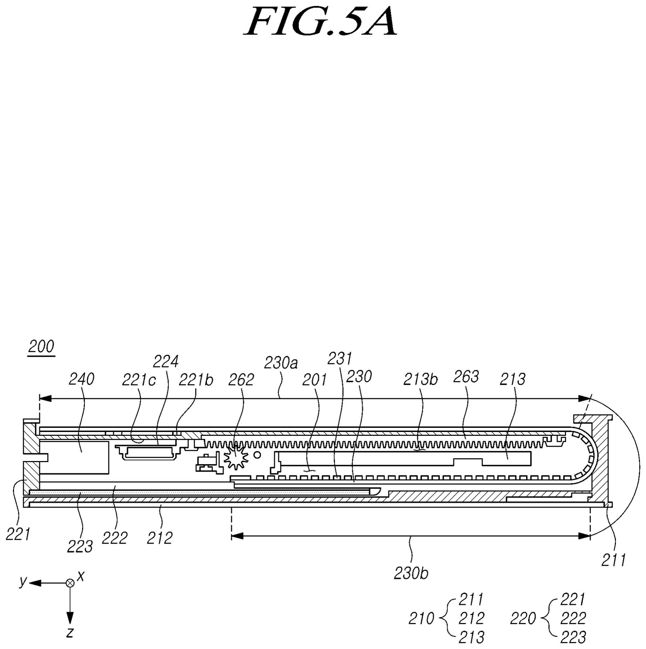

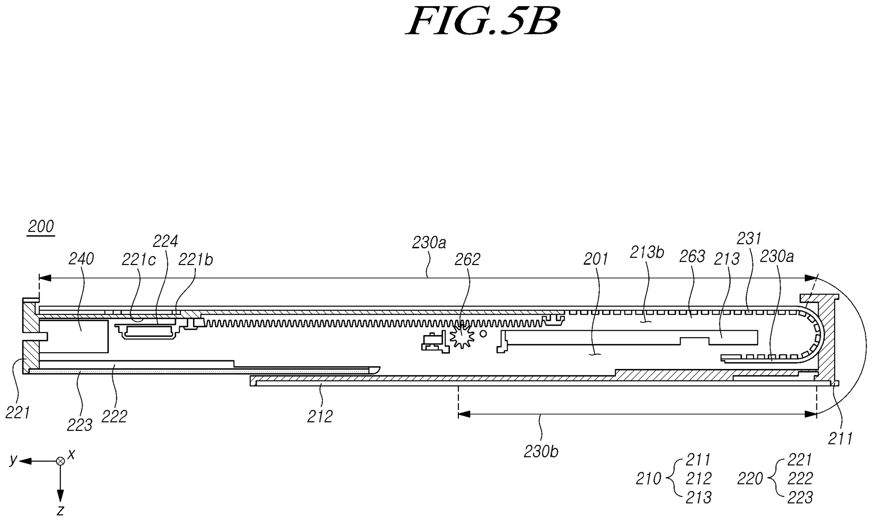

FIG. 4 is an exploded perspective view illustrating an electronic device according to an embodiment. FIG. 5A is a cross-sectional view illustrating an example of the electronic device according to an embodiment, taken along line A-A' of FIG. 2A. FIG. 5B is a cross-sectional view illustrating an example of the electronic device according to an embodiment, taken along line B-B' of FIG. 3A.

Referring to FIGS. 4, 5A, and 5B, an electronic device 200 according to an embodiment may include a first housing 210, a second housing 220, a display 230, a camera 240, a battery 250 (e.g., the battery 189 of FIG. 1), and/or a driving unit 260. According to an embodiment, the first housing 210 and the second housing 220 may be coupled to each other to form an inner space 201 of the electronic device 200. For example, in the first state of the electronic device 200, the second area 230b of the display 230 may be received in the inner space 201.

According to an embodiment, the first housing 210 may include a first supporting member 211, a rear plate 212, and/or a third supporting member 213. According to an embodiment, the first supporting member 211, rear plate 212, and third supporting member 213 included in the first housing 210 may be coupled to each other and may not move in a case where the second housing 220 moves with respect to the first housing 210. According to an embodiment, the first supporting member 211 may form at least a portion of the outer surface of the electronic device 200. For example, the first supporting member 211 may form at least a portion of the side surface of the electronic device 200 and form at least a portion of the rear surface of the electronic device 200. According to an embodiment, the first supporting member 211 may provide a surface on which the rear plate 212 is seated. The rear plate 212 may be seated on one surface of the first supporting member 211.

According to an embodiment, the third supporting member 213 may support internal components of the electronic device 200. For example, the third supporting member 213 may receive the battery 250 and the motor 261 of the driving unit 260. The battery 250 and the motor 261 may be received in at least one of recesses or holes included in the third supporting member 213. According to an embodiment, the third supporting member 213 may be surrounded by the first supporting member 211. For example, in the first state of the electronic device 200, one surface 213a of the third supporting member 213 where the battery 250 is disposed may face the first supporting member 211 and/or the second area 230b of the display 230. As another example, in the first state of the electronic device 200, the other surface 213b of the third supporting member 213 facing a direction opposite to the one surface 213a of the third supporting member 213 may face the first area 230a of the display 230 or the second supporting member 221. For example, the third supporting member 213 may include aluminum as a material, but the disclosure is not limited thereto.

According to an embodiment, the second housing 220 may include a second supporting member 221, a rear cover 222, and/or a slide cover 223. According to an embodiment, the second supporting member 221, rear cover 222, and slide cover 223 may be coupled to each other and may move together with the second housing 220 in a case where the second housing 220 moves with respect to the first housing 210. The second supporting member 221 may support internal components of the electronic device 200. For example, a printed circuit board 224 on which electronic components (e.g., the processor 120 of FIG. 1) of the electronic device 200 are disposed and/or the camera 240 may be disposed on one surface 221c of the second supporting member 221 facing the inner space 201. The other surface 221d of the second supporting member 221 facing a direction opposite to the one surface 221c of the second supporting member 221 may face the first area 230a of the display 230 in a case where the electronic device 200 is in the first state. According to an embodiment, the rear cover 222 may be coupled to the second supporting member 221 to protect components of the electronic device 200 disposed on the second supporting member 221. For example, the rear cover 222 may cover a portion of the one surface 221c of the second supporting member 221. According to an embodiment, the slide cover 223 may be disposed on the rear cover 222 to form the outer surface of the electronic device 200 together with the rear plate 212 and the first supporting member 211. The slide cover 223 may be coupled to one surface of the rear cover 222 or the second supporting member 221 to protect the rear cover 222 and/or the second supporting member 221.

According to an embodiment, in a case where the electronic device 200 is in the first state, the display 230 may be bent as at least a portion thereof is rolled into the inner space 201. According to an embodiment, the display 230 may cover at least a portion of the third supporting member 213 and at least a portion of the second supporting member 221. For example, in a case where the electronic device 200 is in the first state, the display 230 may cover the other surface 221d of the second supporting member 221, pass between the second supporting member 221 and the first supporting member 211, and extend toward the inner space 201. At least a portion of the display 230 may surround at least a portion of the third supporting member 213 after passing between the second supporting member 221 and the first supporting member 211. The display 230 may cover the one surface 213a of the third supporting member 213 in the inner space 201. According to an embodiment, if the second housing 220 moves in the first direction, the second area 230b of the display 230 may be extracted from the inner space 201. For example, as the second housing 220 moves in the first direction, the display 230 may be extracted from the inner space 201 by passing between the second supporting member 221 and the first supporting member 211.

According to an embodiment, the electronic device 200 may include a support bar 231 and a guide rail 232 that support the display 230. For example, the support bar 231 may include a plurality of bars coupled to each other and may be manufactured in a shape corresponding to the shape of the second area 230b of the display 230. According to an embodiment, the support bar 231 may move together with the display 230 as the display 230 moves. According to an embodiment, in the first state where the second area 230b of the display 230 is rolled in the inner space 201, the support bar 231 may be rolled in the inner space 201 together with the second area 230b of the display 230. The support bar 231 may move together with the second area 230b of the display 230 as the second housing 220 moves in the first direction. According to an embodiment, the guide rail 232 may guide the movement of the support bar 231. For example, as the display 230 moves, the support bar 231 may move along the guide rail 232 coupled to the third supporting member 213. According to an embodiment, the guide rail 232 may be coupled to the third supporting member 213 or the first supporting member 211. For example, the guide rail 232 may include a plurality of guide rails 232 disposed to be spaced apart from each other at two opposite edges of the third supporting member 213 that are spaced apart from each other along a third direction (e.g., +x direction) perpendicular to the first direction.

According to an embodiment, the driving unit 260 may provide driving force to the second housing 220 so that the second housing 220 may move relative to the first housing 210. According to an embodiment, the driving unit 260 may include a motor 261, a pinion gear 262, and/or a rack gear 263. The motor 261 may receive power from the battery 250 to provide driving force to the second housing 220. According to an embodiment, the motor 261 may be disposed in the first housing 210 and may not move in a case where the second housing 220 moves with respect to the first housing 210. For example, the motor 261 may be disposed in a recess formed in the third supporting member 213. According to an embodiment, the pinion gear 262 may be coupled to the motor 261 and may be rotated by the driving force provided from the motor 261. According to an embodiment, the rack gear 263 may mesh with the pinion gear 262 and may move according to the rotation of the pinion gear 262. For example, the rack gear 263 may perform linear reciprocating motion in the first direction or the second direction according to the rotation of the pinion gear 262. According to an embodiment, the rack gear 263 may be disposed in the second housing 220. For example, the rack gear 263 may be coupled to the second supporting member 221 included in the second housing 220. According to an embodiment, the rack gear 263 may be movable inside an operating space 213p formed in the third supporting member 213.

According to an embodiment, if the pinion gear 262 rotates along a first rotational direction (e.g., the clockwise direction in FIG. 5A), the rack gear 263 may move in the first direction (e.g., +y direction). If the rack gear 263 moves along the first direction, the second housing 220 coupled to the rack gear 263 may move along the first direction. As the second housing 220 moves along the first direction, the area of the display 230 visible from outside the electronic device 200 may be extended. If the pinion gear 262 rotates along a second rotational direction (e.g., the counterclockwise direction in FIG. 5A), the rack gear 263 may move in the second direction (e.g., -y direction). If the rack gear 263 moves along the second direction, the second housing 220 coupled to the rack gear 263 may move along the second direction. As the second housing 220 moves along the second direction, the area of the display 230 visible from outside the electronic device 200 may be reduced.

In the above description, it is described that the motor 261 and pinion gear 262 are disposed in the first housing 210, and the rack gear 263 is disposed in the second housing 220, but embodiments may not be limited thereto. According to embodiments, the motor 261 and pinion gear 262 may be disposed in the second housing 220, and the rack gear 263 may be disposed in the first housing 210.

In FIGS. 2A to 5B, an embodiment has been illustrated or described for a structure in which the display 230 extends or contracts in the vertical direction. However, this is exemplary, and it may be possible to change and apply the structure of the first housing 210 and the second housing 220 so that the display 230 extends or contracts in the horizontal direction.

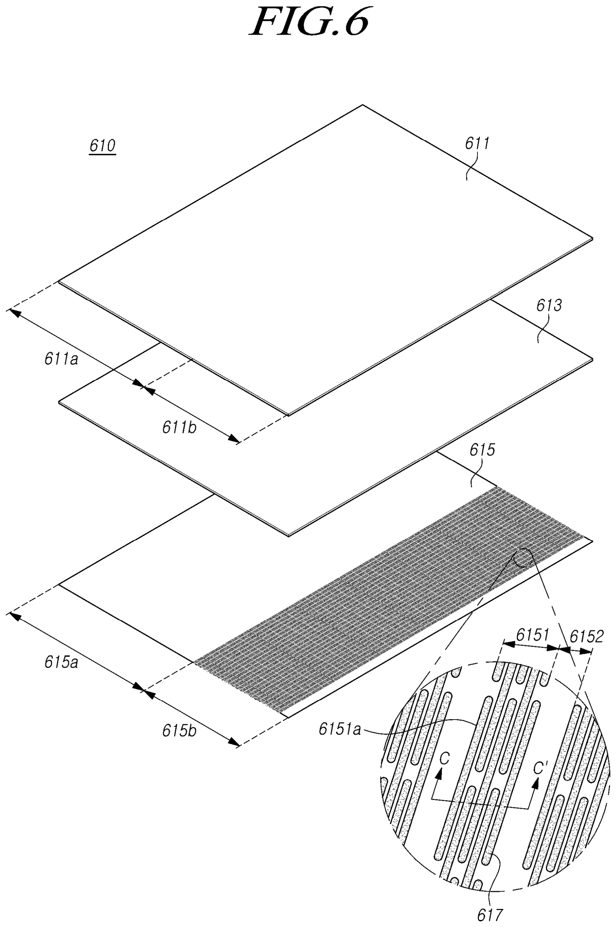

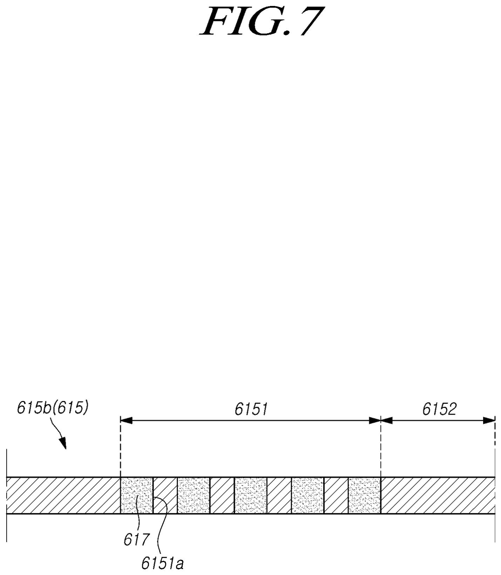

FIG. 6 is an exploded perspective view illustrating a flexible display assembly according to an embodiment. FIG. 7 is a cross-sectional view illustrating an example of the support plate according to an embodiment, taken along line C-C' of FIG. 6.

The flexible display assembly 610 (e.g., the display 230 of FIG. 2A) of FIG. 6 may be included in the electronic device 200 of FIG. 2A.

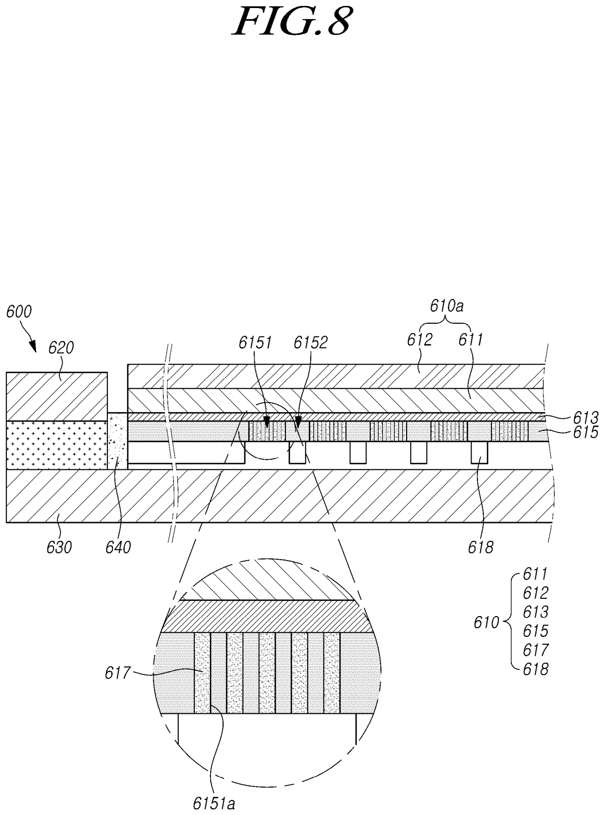

FIG. 6 is a view illustrating the coupling relationship between the display panel 611, support plate 615, first heat dissipation member 613 provided between the display panel 611 and support plate 615, and second heat dissipation member 617 filling the space portions 6151a of the support plate 615, and other additional components or coupling structures of the components may are present. For example, a window member (e.g., the window member 612 of FIG. 8) for protecting the display panel may be provided on the upper side of the display panel 611, but is omitted in FIG. 6 for convenience of description. For example, the display panel 611 and support plate 615 may be indirectly coupled with additional components therebetween.

Referring to FIGS. 6 and 7, the display assembly 610 may include at least one of a display panel 611, a support plate 615, a first heat dissipation member 613, or a second heat dissipation member 617. The display assembly 610 may have the display panel 611, first heat dissipation member 613, and support plate 615 sequentially disposed from the top. Other components may be additionally disposed between the display panel 611 and the first heat dissipation member 613. The display panel 611 may be disposed to be directly or indirectly adjacent to the first heat dissipation member 613. Other components may be additionally disposed between the first heat dissipation member 613 and the support plate 615. The first heat dissipation member 613 may be disposed to be directly or indirectly adjacent to the support plate 615.

According to an example, the display panel 611 may include a first area 611a (e.g., planar area) and a second area 611b (e.g., flexible area). For example, the first area 611a of the display panel 611 may be an area corresponding to the first area 230a of FIG. 3A. For example, the second area 611b of the display panel 611 may be an area corresponding to the second area 230b of FIG. 3A.

According to an example, the support plate 615 may include a fixed area 615a and a flexible area 615b. The fixed area 615a may, e.g., be positioned in a portion corresponding to the first area 611a of the display panel 611. The fixed area 615a may, e.g., be disposed to be directly or indirectly adjacent to the rear surface of the first area 611a of the display panel 611. The flexible area 615b may, e.g., be positioned in a portion corresponding to the second area 611b of the display panel 611. The flexible area 615b may, e.g., be disposed to be directly or indirectly adjacent to the rear surface of the second area 611b of the display panel 611. The fixed area 615a and flexible area 615b may be integrally formed.

According to an example, the support plate 615 may include a stretchable portion 6151 and a support portion 6152 positioned in the flexible area 615b. The support plate 615 may include a plurality of stretchable portions 6151 and a plurality of support portions 6152. The stretchable portions 6151 and support portions 6152 may be alternately disposed in the flexible area 615b of the support plate 615. The stretchable portions 6151 and support portions 6152 may, e.g., be alternately disposed along the length direction of the support plate 615. The length direction of the support plate 615 may refer to the y-axis direction. The elastic or stretchable portion 6151 or the support portion 6152 may be formed to be elongated in a direction perpendicular to the length direction of the support plate 615, for example.

According to an example, the support plate 615 may include a plurality of space portions 6151a. According to an example, the stretchable portions 6151 may include a plurality of space portions 6151a. By forming a plurality of space portions 6151a in the stretchable portions 6151, the bending performance of the flexible area 615b of the support plate 615 may be enhanced. The space portions 6151a may, e.g., have an oval shape that is long in a direction perpendicular to the length direction of the support plate 615 as illustrated. However, it is not limited thereto and may have a rectangular shape that is long in a direction perpendicular to the length direction of the support plate 615. The direction perpendicular to the length direction of the support plate 615 may be the length direction of the stretchable portions 6151 or the x-axis direction. The space portions 6151a may be formed as through holes that penetrate the support plate 615 vertically as illustrated, but the disclosure is not limited thereto. For example, the space portions 6151a may have a recess shape dug from one surface without penetrating the support plate 615, unlike illustrated. In a case where the space portions 6151a have a recess shape unlike illustrated, the space portions 6151a may be dug from the surface of the support plate 615 that contacts the first heat dissipation member 613.

The plurality of space portions 6151a may be formed in the stretchable portions 6151 according to a predetermined pattern. For example, the plurality of space portions 6151a may be disposed in a lattice pattern as illustrated in FIG. 6.

In an example, the plurality of space portions 6151a formed in the stretchable portions 6151 may be formed through, e.g., a piercing process of press working, but the disclosure is not limited thereto.

In an example, the portions where the plurality of space portions 6151a are formed in the flexible area 615b may be referred to as stretchable portions 6151, and the other portions may be referred to as support portions 6152.

According to an example, the support plate 615 may be formed of various metallic materials and/or non-metallic materials (e.g., polymers). The support plate 615 may include, e.g., stainless steel. The support plate 615 may include, e.g., engineering plastic. The support plate 615 may, e.g., be implemented integrally with the display panel 611.

According to an example, the first heat dissipation member 613 may be disposed between the display panel 611 and the support plate 615. The first heat dissipation member 613 may be configured to have higher thermal conductivity than the support plate 615.

The first heat dissipation member 613 may be formed of materials with excellent thermal conductivity or heat dissipation. The first heat dissipation member 613 may include, e.g., at least one of metallic materials with excellent thermal conductivity such as silver, copper, copper alloys, aluminum, carbon-based materials such as graphite and graphene, silicon oil-based materials mixed with thermally conductive powders such as aluminum oxide, mono-crystalline diamond, zinc oxide, metal particles, or liquid metal materials such as Galinstan thermal compounds, but the disclosure is not limited thereto.

The first heat dissipation member 613 may be, e.g., a paste or grease type, but the disclosure is not limited thereto. The first heat dissipation member 613 may include, e.g., at least one of thermal grease, thermal sheet/film, thermal PAD, and thermal adhesive.

According to an example, the second heat dissipation member 617 may fill the space portions 6151a of the support plate 615. The second heat dissipation member 617 may be disposed to fill the empty space formed by the space portions 6151a. The second heat dissipation member 617 may be configured to have higher thermal conductivity than the support plate 615.

The second heat dissipation member 617 may be formed of materials with excellent thermal conductivity or heat dissipation. The second heat dissipation member 617 may include, e.g., at least one of metallic materials with excellent thermal conductivity such as silver, copper, copper alloys, aluminum, carbon-based materials such as graphite and graphene, silicon oil-based materials mixed with thermally conductive powders such as aluminum oxide, mono-crystalline diamond, zinc oxide, metal particles, or liquid metal materials such as Galinstan thermal compounds.

The second heat dissipation member 617 may be, e.g., a paste or grease type, but the disclosure is not limited thereto. The second heat dissipation member 617 may include, e.g., at least one of thermal grease, thermal sheet/film, thermal PAD, and thermal adhesive.

FIG. 8 is a cross-sectional view schematically illustrating a heat dissipation structure of an electronic device according to an embodiment.

FIG. 8 is an exemplary view that simplifies the coupling relationship to easily describe the heat dissipation structure of the electronic device 600 (e.g., the electronic device 101 of FIG. 1 or electronic device 200 of FIG. 2A), and the position of each component is not limited to what is illustrated. For example, the circuit board 620 (e.g., the printed circuit board 224 of FIG. 4) or battery 630 (e.g., the battery 250 of FIG. 4) may be disposed at various positions according to design in the inner space of the electronic device 600.

Some of the components of the display assembly 610 have been described in detail in FIGS. 6 and 7, so redundant descriptions are omitted below.

Referring to FIG. 8, the electronic device 600 may include all or some of a flexible display 610a, a support plate 615, a support bar 618, a first heat dissipation member 613, a second heat dissipation member 617, a third heat dissipation member 640, or at least one heat generating element 620, 630. The flexible display 610a, support plate 615, support bar 618, first heat dissipation member 613, and second heat dissipation member 617 may constitute the display assembly 610.

According to an example, the at least one heat generating element 620, 630 may be disposed in the inner space of the electronic device 600. The at least one heat generating element 620, 630 may be disposed inside the first housing (e.g., the first housing 210 of FIG. 2A) or second housing (e.g., the second housing 220 of FIG. 2A) of the electronic device 600. The at least one heat generating element 620, 630 may include, e.g., at least one of a circuit board 620, a battery 630, or a motor (e.g., the motor 261 of FIG. 4). The circuit board 620 may be, e.g., a flexible printed circuit board.

The flexible display 610a may be substantially identical or similar to the display 230 described with reference to FIGS. 2A to 5B. The flexible display 610a may include a window member 612 and a display panel 611. The window member 612 may be disposed on the upper side of the display panel 611. The window member 612 may be provided to protect the display panel 611 from external impact. The window member 612 may be formed of a transparent glass material.

According to an example, the flexible display 610a, support plate 615, first heat dissipation member 613, and second heat dissipation member 617 may be combined to constitute one flexible display assembly 610.

According to an example, the first heat dissipation member 613 may be disposed on the lower side of the flexible display 610a. The first heat dissipation member 613 may be disposed between the flexible display 610a and the support plate 615.

According to an example, the first heat dissipation member 613 may be disposed to span across a first area (e.g., the first area 230a of FIG. 3A) and a second area (e.g., the second area 230b of FIG. 3A) of the flexible display 610a. A portion of the first heat dissipation member 613 may be disposed on the lower side of the first area 611a of the flexible display 610a. Another portion of the first heat dissipation member 613 may be disposed on the lower side of the second area 611b of the flexible display 610a.

According to an example, the first heat dissipation member 613 may be disposed to span across the fixed area (e.g., the fixed area 615a of FIG. 6) and flexible area (e.g., the flexible area 615b of FIG. 6) of the support plate 615. A portion of the first heat dissipation member 613 may be disposed on the fixed area 615a of the support plate 615. Another portion of the first heat dissipation member 613 may be disposed on the flexible area 615b of the support plate 615.

As described above, by providing at least a portion of the first heat dissipation member 613 in places corresponding to the second area 611b of the flexible display 610a or the flexible area 615b of the support plate 615, the area of the first heat dissipation member 613 may increase to face outward in a case where the electronic device 600 is in the second state (e.g., extracted state, open state, or slide-out state). Accordingly, heat dissipation efficiency may be increased in the second state of the electronic device 600.

According to an example, the support plate 615 may be disposed on the lower side of the first heat dissipation member 613. According to an example, the support bar 618 may be disposed on the lower side of the support plate 615. The support bar 618 may be adhered to the support portions 6152 of the support plate 615. The support bar 618 may be configured to be disposed on the lower side of the portion of the support plate 615 corresponding to the second area 611b (or flexible area) of the display panel 611. A plurality of support bars 618 may be disposed to be spaced apart from each other at predetermined intervals.

According to an example, the second heat dissipation member 617 may be disposed in the space portions 6151a of the support plate 615. The second heat dissipation member 617 may be disposed not to protrude to the upper side or lower side of the support plate 615. For example, the second heat dissipation member 617 may fill to form a flat surface with respect to at least one of the upper surface or lower surface of the support plate 615. The second heat dissipation member 617 may be disposed to contact the first heat dissipation member 613.

According to an example, the third heat dissipation member 640 may be disposed to contact the at least one heat generating element 620, 630. Heat generated from the at least one heat generating element 620, 630 may be transferred to the third heat dissipation member 640.

According to an example, the third heat dissipation member 640 may be disposed between at least one of the first heat dissipation member 613 or support plate 615 and the at least one heat generating element 620, 630. The third heat dissipation member 640 may contact the at least one heat generating element 620, 630. The third heat dissipation member 640 may contact the first heat dissipation member 613. The third heat dissipation member 640 may contact the support plate 615.

According to an example, the third heat dissipation member 640 may be disposed to contact at least one of the first heat dissipation member 613 or support plate 615. The third heat dissipation member 640 may be configured to transfer heat received from the at least one heat generating element 620, 630 to at least one of the first heat dissipation member 613 or support plate 615.

According to an example, the third heat dissipation member 640 may be disposed to contact the first heat dissipation member 613 and support plate 615. The third heat dissipation member 640 may transfer heat generated from the at least one heat generating element 620, 630 disposed inside the electronic device 600 to the first heat dissipation member 613 or support plate 615.

The third heat dissipation member 640 may be formed of materials with excellent thermal conductivity or heat dissipation. The third heat dissipation member 640 may include, e.g., at least one of metallic materials with excellent thermal conductivity such as silver, copper, copper alloys, aluminum, carbon-based materials such as graphite and graphene, silicon oil-based materials mixed with thermally conductive powders such as aluminum oxide, mono-crystalline diamond, zinc oxide, metal particles, or liquid metal materials such as Galinstan thermal compounds.

According to an example, the third heat dissipation member 640 may be included in the display assembly 610.

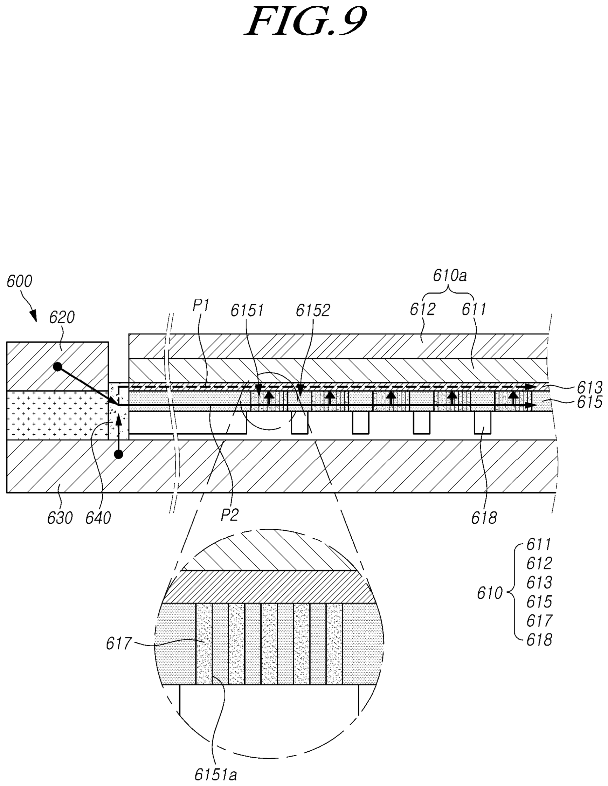

FIG. 9 is a cross-sectional view schematically illustrating a heat dissipation process of an electronic device according to an embodiment.

FIG. 9 is an exemplary view that simplifies the coupling relationship to easily describe the heat dissipation structure of the electronic device 600 (e.g., the electronic device 101 of FIG. 1 or electronic device 200 of FIG. 2A), and the position of each component is not limited to what is illustrated. For example, the circuit board 620 or battery 630 may be disposed at various positions according to design in the inner space of the electronic device 600.

Referring to FIG. 9, heat may be generated inside while the electronic device 600 operates. If the electronic device 600 operates, heat may be generated by the at least one heat generating element 620, 630 disposed in the electronic device 600. The at least one heat generating element 620, 630 may include a circuit board 620 or a battery 630 as illustrated in FIG. 9, but the disclosure is not limited thereto. Hereinafter, a structure for dissipating heat generated from the circuit board 620 and battery 630 is described as an example, but the disclosure is not limited thereto and may be applied to structures for dissipating other heat generating elements.

According to an example, heat generated from the circuit board 620 or battery 630 may be transferred directly or indirectly to the third heat dissipation member 640. Heat transferred to the third heat dissipation member 640 may be transferred to at least one of the first heat dissipation member 613 and support plate 615 that contact the third heat dissipation member 640.

According to an example, the thermal conductivity of the first heat dissipation member 613 may be larger than that of the support plate 615. Therefore, the speed at which heat from the third heat dissipation member 640 is transferred to the first heat dissipation member 613 may be faster than the speed at which heat from the third heat dissipation member 640 is transferred to the support plate 615.

According to an example, the electronic device 600 may be configured so that heat generated from the circuit board 620 or battery 630 is dissipated to the outside through at least two paths (hereinafter referred to as a first path P1 and a second path P2).

According to an example, the first path P1 may be a path where heat generated from the circuit board 620 or battery 630 is sequentially transferred to the third heat dissipation member 640 and first heat dissipation member 613 and dissipated to the surface of the flexible display 610a. Since heat from the third heat dissipation member 640 passes through the first heat dissipation member 613 and is directly dissipated to the outside, the first path P1 may be referred to as a rapid heat dissipation path.

According to an example, the second path P2 may be a path where heat generated from the circuit board 620 or battery 630 is sequentially transferred to the third heat dissipation member 640, support plate 615, second heat dissipation member 617, and first heat dissipation member 613 and dissipated to the surface of the flexible display 610a. Since the support plate 615 has lower thermal conductivity than the first heat dissipation member 613, the amount of heat transferred from the third heat dissipation member 640 may be small. Further, the second path P2 may have a more complex path for transferring heat than the first path P1. Since the speed at which heat is dissipated through the second path P2 is slower than the speed at which heat is dissipated through the first path P1, it may be referred to as a delayed heat dissipation path.

According to an example, the first heat dissipation member 613 may be disposed across the first area (e.g., the first area 230a of FIG. 3A) and second area (e.g., the second area 230b of FIG. 3A) of the flexible display 610a. Therefore, in a case where the electronic device 600 is extracted to the second state (e.g., extracted state, open state, or slide-out state), a portion of the first heat dissipation member 613 disposed in the housing is also extracted to face outward, so the amount of heat dissipation may increase. Therefore, the heat dissipation structure of the electronic device 600 according to an embodiment may have larger heat dissipation efficiency in slidable electronic devices.

The electronic device 600 according to an embodiment may primarily dissipate heat through the first path P1 and secondarily dissipate heat through the second path P2. The second path P2 may, e.g., serve as a buffer. The electronic device 600 according to an embodiment may control the amount of heat dissipated using two paths to control the heat sensation that the user feels on the surface of the flexible display 610a.

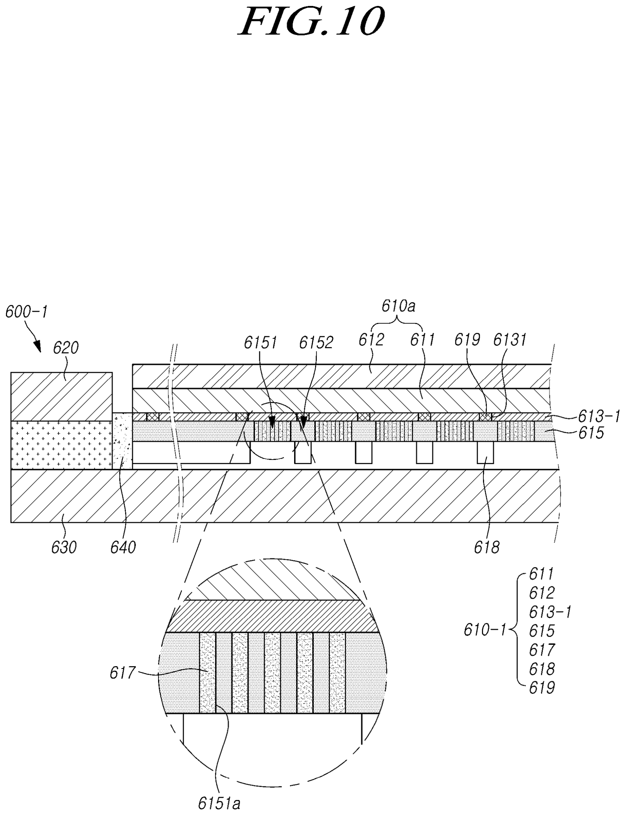

FIG. 10 is a cross-sectional view schematically illustrating a heat dissipation structure with enhanced adhesion in an electronic device according to an embodiment.

FIG. 10 is an exemplary view that simplifies the coupling relationship to easily describe the heat dissipation structure of the electronic device 600-1 (e.g., the electronic device 101 of FIG. 1 or electronic device 200 of FIG. 2A), and the position of each component is not limited to what is illustrated. For example, the circuit board 620 (e.g., the printed circuit board 224 of FIG. 4) or battery 630 (e.g., the battery 250 of FIG. 4) may be disposed at various positions according to design in the inner space of the electronic device 600-1.

Among the components of the schematic structure of the electronic device 600-1 illustrated in FIG. 10, the same reference numerals are used for components that are substantially the same as the components of the electronic device 600 illustrated in FIG. 8.

Referring to FIG. 10, the display assembly 610-1 may include a first heat dissipation member 613-1 having a plurality of first heat dissipation member holes 6131 formed therein. The first heat dissipation member 613-1 of FIG. 10 may have a plurality of first heat dissipation member holes 6131 formed therein, unlike the first heat dissipation member 613 of FIG. 8. The plurality of first heat dissipation member holes 6131 may be provided to be spaced apart from each other at predetermined intervals. Some of the plurality of first heat dissipation member holes 6131 may be formed at positions corresponding to the support portions 6152 in the flexible area 615b of the support plate 615.

According to an example, the display assembly 610-1 may further include a first adhesive member 619. The first adhesive member 619 may be configured to fill the first heat dissipation member holes 6131. One side of the first adhesive member 619 may, e.g., be adhered to the flexible display 610a (or display panel), but the disclosure is not limited thereto. The other side of the first adhesive member 619 may, e.g., be adhered to the support plate 615. The first adhesive member 619 may enhance the adhesion between the flexible display 610a (or display panel) and the first heat dissipation member 613-1. The first adhesive member 619 may enhance the adhesion between the first heat dissipation member 613-1 and the support plate 615. By forming the plurality of first heat dissipation member holes 6131 in the first heat dissipation member 613-1 and filling the space with the first adhesive member 619, it is possible to prevent delamination of the first heat dissipation member from the flexible display 610a or support plate 615 due to loss of adhesion. Further, by filling the first heat dissipation member holes 6131 rather than adding a separate layer for the first adhesive member, the adhesion of the first heat dissipation member 613-1 may be enhanced while maintaining the thickness of the display assembly 610-1.

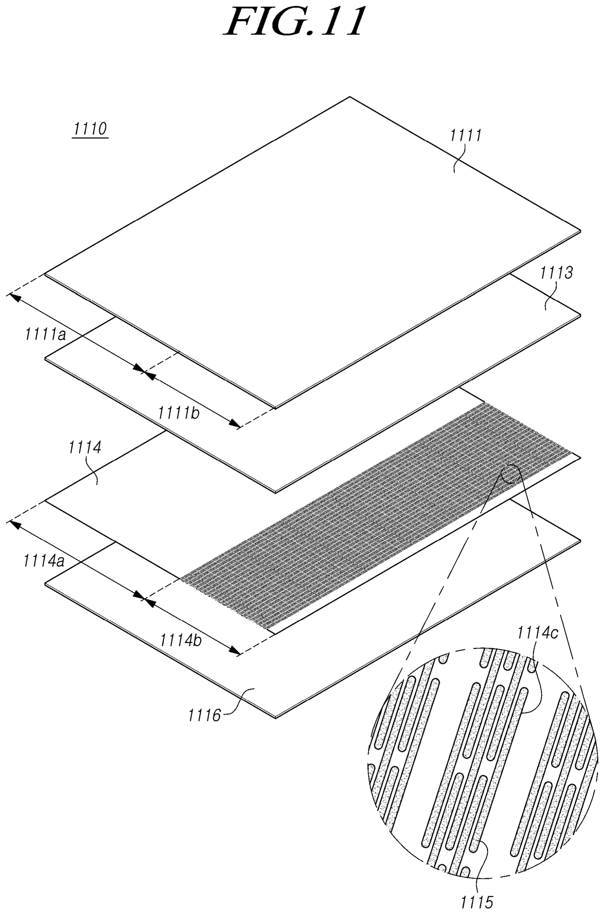

FIG. 11 is an exploded perspective view illustrating a flexible display assembly according to an embodiment.

The flexible display assembly 1110 (e.g., the display 230 of FIG. 2A) of FIG. 11 may be included in the electronic device 200 of FIG. 2A.

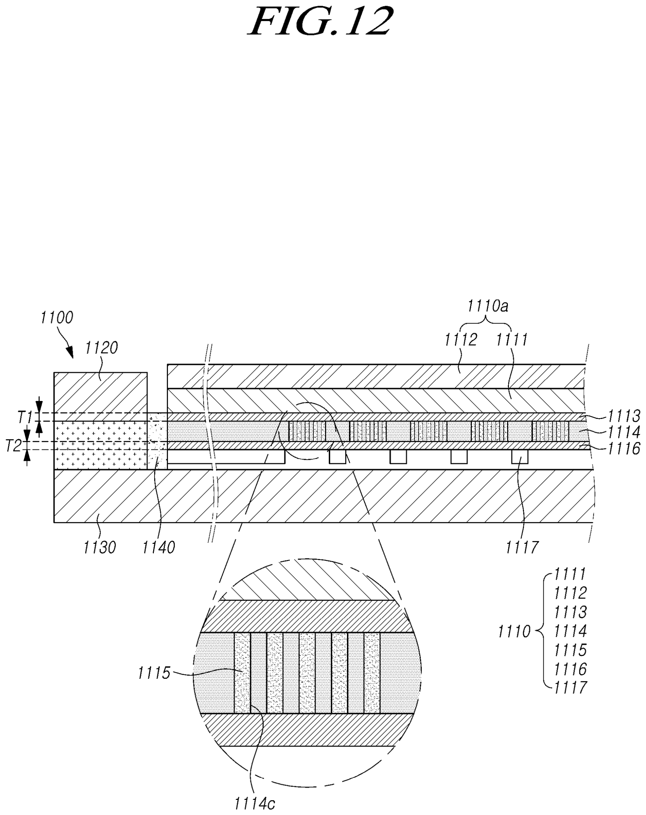

FIG. 11 is a view illustrating the coupling relationship between the display panel 1111, the support plate 1114, the first heat dissipation member 1113 provided between the display panel 1111 and the support plate 1114, the second heat dissipation member 1115 filling the space portion 1114c of the support plate 1114, and the fourth heat dissipation member 1116 provided on the lower side of the support plate 1114, and other additional components or coupling structures of the components may are present. For example, a window member (e.g., the window member 1112 of FIG. 12) for protecting the display panel may be provided on the upper side of the display panel 1111, but is omitted in FIG. 11 for convenience of description. For example, the display panel 1111 and support plate 1114 may be indirectly coupled with additional components therebetween.

The same reference numbers are used to denote substantially the same components as the components described with reference to FIG. 6 among the components of the display assembly 1110 of FIG. 11. The display panel 1111 may be substantially identical or similar to the display panel 611 of FIG. 6. The support plate 1114 may be substantially identical or similar to the support plate 615 of FIG. 6. The first heat dissipation member 1113 may be substantially identical or similar to the first heat dissipation member 613 of FIG. 6. The second heat dissipation member 1115 may be substantially identical or similar to the second heat dissipation member 617 of FIG. 6. Descriptions of overlapping components and their coupling relationships are omitted hereinafter.

Referring to FIG. 11, the display assembly 1110 may include at least one of the display panel 1111, the support plate 1114, the first heat dissipation member 1113, the second heat dissipation member 1115, or the fourth heat dissipation member 1116. In the display assembly 1110, the display panel 1111, the first heat dissipation member 1113, the support plate 1114, and the fourth heat dissipation member 1116 may be sequentially disposed from the top. Other components may be additionally disposed between the display panel 1111 and the first heat dissipation member 1113. The display panel 1111 may be disposed to be directly or indirectly adjacent to the first heat dissipation member 1113.

According to an example, the fourth heat dissipation member 1116 may be disposed on the lower side of the support plate 1114. The fourth heat dissipation member 1116 may be disposed to contact a lower surface of the support plate 1114. The fourth heat dissipation member 1116 may be disposed to contact the second heat dissipation member 1115. The fourth heat dissipation member 1116 and the second heat dissipation member 1115 may be disposed to enable heat exchange with each other. The fourth heat dissipation member 1116 may be disposed, e.g., between the support plate 1114 and the support bar 1117.

The fourth heat dissipation member 1116 may be formed of a material having excellent thermal conductivity or heat dissipation. The fourth heat dissipation member 1116 may include, e.g., at least one of metallic materials with excellent thermal conductivity such as silver, copper, copper alloys, aluminum, carbon-based materials such as graphite and graphene, silicon oil-based materials mixed with thermally conductive powders such as aluminum oxide, mono-crystalline diamond, zinc oxide, metal particles, or liquid metal materials such as Galinstan thermal compounds.

The fourth heat dissipation member 1116 may be, e.g., a paste or grease type, but the disclosure is not limited thereto. The fourth heat dissipation member 1116 may include, e.g., at least one of thermal grease, thermal sheet/film, thermal PAD, and thermal adhesive.

FIG. 12 is a cross-sectional view schematically illustrating a heat dissipation structure of an electronic device according to an embodiment.

FIG. 12 is an exemplary view that simplifies the coupling relationship to easily describe the heat dissipation structure of the electronic device 1100 (e.g., the electronic device 101 of FIG. 1 or electronic device 200 of FIG. 2A), and the position of each component is not limited to what is illustrated. For example, the circuit board 1120 (e.g., the **printed circuit board 224** of FIG. 4) or battery 1130 (e.g., the battery 250 of FIG. 4) may be disposed at various positions according to design in the inner space of the electronic device 1100.

Referring to FIG. 12, the electronic device 1100 may include all or some of a flexible display 1110a, a support plate 1114, a support bar 1117, a first heat dissipation member 1113, a second heat dissipation member 1115, a third heat dissipation member 1140, a fourth heat dissipation member 1116, or at least one heat generating element 1120, 1130. The flexible display 1110a, support plate 1114, support bar 1117, first heat dissipation member 1113, second heat dissipation member 1115, and fourth heat dissipation member 1116 may constitute the display assembly 1110. The flexible display 1110a may include at least one of a window member 1112 or a display panel 1111.

The flexible display 1110a may be substantially identical or similar to the flexible display 610a of FIG. 8. The support plate 1114 may be substantially identical or similar to the support plate 615 of FIG. 8. The support bar 1117 may be substantially identical or similar to the support bar 618 of FIG. 8. The first heat dissipation member 1113 may be substantially identical or similar to the first heat dissipation member 613 of FIG. 8. The second heat dissipation member 1115 may be substantially identical or similar to the second heat dissipation member 617 of FIG. 8. The third heat dissipation member 1140 may be substantially identical or similar to the third heat dissipation member 640 of FIG. 8. The at least one heat generating element 1120, 1130 may be substantially identical or similar to the at least one heat generating element 1120, 1130 of FIG. 8. Descriptions of overlapping components and their coupling relationships are omitted hereinafter.

According to an example, the fourth heat dissipation member 1116 may be disposed on the lower side of the support plate 1114. The fourth heat dissipation member 1116 may be disposed between the support plate 1114 and the support bar 1117, but the disclosure is not limited thereto. For example, the fourth heat dissipation member 1116 may be disposed on the lower side of the support plate 1114 and the support bar 1117 in a state in which the support bar 1117 is adhered to the support plate 1114. The fourth heat dissipation member 1116 may be configured to have adhesion and may be adhered to at least one of the support plate 1114 or the support bar 1117.

According to an example, the first heat dissipation member 1113 and the fourth heat dissipation member 1116 may have different thicknesses. In a case where the display assembly 1110 is bent by a sliding operation of the electronic device 1100, the first heat dissipation member 1113 may be bent toward the outside of the fourth heat dissipation member 1116 at the bending portion. For example, at the portion where the display assembly 1110 is bent, the bending radius of the first heat dissipation member 1113 may be larger than the bending radius of the fourth heat dissipation member 1116. To apply the same magnitude of tensile stress to the first heat dissipation member 1113 and the fourth heat dissipation member 1116 having different bending radii, the first thickness T1 of the first heat dissipation member 1113 may be configured to be thicker than the second thickness T2 of the fourth heat dissipation member 1116. A ratio of the thickness difference between the first heat dissipation member 1113 and the fourth heat dissipation member 1116 may vary according to the difference between the bending radius of the first heat dissipation member 1113 and the bending radius of the fourth heat dissipation member 1116. As an example, the first heat dissipation member 1113 may have a thickness about 10% to about 55% larger than the fourth heat dissipation member 1116, but the disclosure is not limited thereto.

According to an example, the first heat dissipation member 1113 and the fourth heat dissipation member 1116 may have different modulus properties. As described above, since the bending radius of the first heat dissipation member 1113 is larger than the bending radius of the fourth heat dissipation member 1116, bending stress applied to the first heat dissipation member 1113 during bending may be smaller than bending stress applied to the fourth heat dissipation member 1116. To compensate for different bending stresses, the modulus properties of the first heat dissipation member 1113 and the fourth heat dissipation member 1116 may be configured differently. The first heat dissipation member 1113 may be configured to have a lower modulus than the fourth heat dissipation member 1116. As an example, the fourth heat dissipation member 1116 may have modulus properties about 10% to about 55% higher than the first heat dissipation member 1113, but the disclosure is not limited thereto.

According to an example, the second heat dissipation member 1115 may have different modulus properties from the first heat dissipation member 1113 or the fourth heat dissipation member 1116. Since the second heat dissipation member 1115 is disposed between the first heat dissipation member 1113 and the fourth heat dissipation member 1116, the modulus properties of the second heat dissipation member 1115 may be smaller than the modulus properties of the first heat dissipation member 1113 or larger than the modulus properties of the fourth heat dissipation member 1116.

According to an example, the third heat dissipation member 1140 may be disposed not to contact the support plate 1114, unlike illustrated. The third heat dissipation member 1140 may be disposed to contact the first heat dissipation member 1113 and the fourth heat dissipation member 1116 so that heat from the third heat dissipation member 1140 is transferred only to the first heat dissipation member 1113 and the fourth heat dissipation member 1116.

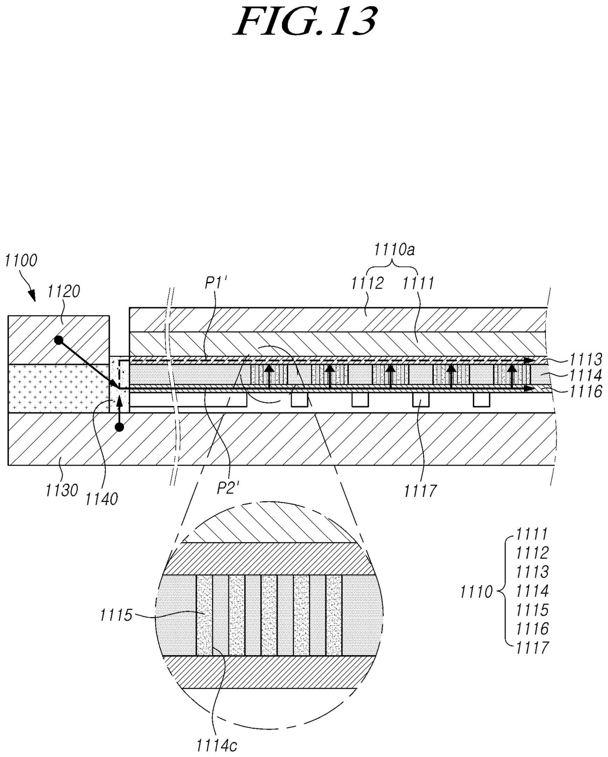

FIG. 13 is a cross-sectional view schematically illustrating a heat dissipation process of an electronic device according to an embodiment.

FIG. 13 is an exemplary view that simplifies the coupling relationship to easily describe the heat dissipation structure of the electronic device 1100 (e.g., the electronic device 101 of FIG. 1 or electronic device 200 of FIG. 2A), and the position of each component is not limited to what is illustrated. For example, the circuit board 1120 or battery 1130 may be disposed at various positions according to design in the inner space of the electronic device 1100.

Referring to FIG. 13, heat may be generated inside while the electronic device 1100 operates. If the electronic device 1100 operates, heat may be generated by the at least one heat generating element 1120, 1130 disposed in the electronic device 1100. The at least one heat generating element 1120, 1130 may include a circuit board 1120 or a battery 1130 as illustrated in FIG. 13, but the disclosure is not limited thereto. Hereinafter, a structure for dissipating heat generated from the circuit board 1120 and battery 1130 is described as an example, but the disclosure is not limited thereto and may be applied to structures for dissipating other heat generating elements.

According to an example, heat generated from the circuit board 1120 or battery 1130 may be transferred directly or indirectly to the third heat dissipation member 1140. Heat transferred to the third heat dissipation member 1140 may be transferred to the first heat dissipation member 1113 and the fourth heat dissipation member 1116 in contact with the third heat dissipation member 1140.

According to an example, the electronic device 1100 may be configured so that heat generated from the circuit board 1120 or battery 1130 is dissipated to the outside through at least two paths (hereinafter referred to as a first path P1' and a second path P2').

According to an example, the first path P1' may denote a path where heat generated from the circuit board 1120 or battery 1130 is sequentially transferred to the third heat dissipation member 1140 and first heat dissipation member 1113 and dissipated to the surface of the flexible display 1110a. Heat from the third heat dissipation member 1140 may pass through the first heat dissipation member 1113 and be dissipated directly to the outside.

According to an example, the second path P2' may denote a path where heat generated from the circuit board 1120 or battery 1130 is sequentially transferred to the third heat dissipation member 1140, fourth heat dissipation member 1116, second heat dissipation member 1115, and first heat dissipation member 1113 and dissipated to the surface of the flexible display 1110a.

According to an example, the first heat dissipation member 1113 and the fourth heat dissipation member 1116 may have different thermal conductivities. For example, the thermal conductivity of the first heat dissipation member 1113 may be larger than thermal conductivity of the fourth heat dissipation member 1116. Therefore, heat transferred from the third heat dissipation member 1140 may be transferred more to the first heat dissipation member 1113 than the fourth heat dissipation member 1116. Accordingly, the speed at which heat is dissipated through the first path P1' becomes faster than the speed at which heat is dissipated through the second path P2', and heat dissipated through the second path P2' may serve as a buffer.

According to an example, the fourth heat dissipation member 1116 may be disposed to face the battery 1130 with a predetermined interval therebetween. In a case where heat is generated from the battery 1130, the heat may be transferred to the fourth heat dissipation member 1116 through the inner space of the electronic device 1100. By additionally configuring the fourth heat dissipation member 1116 on the lower side of the support plate 1114, the heat dissipation efficiency for the battery 1130 may be increased.

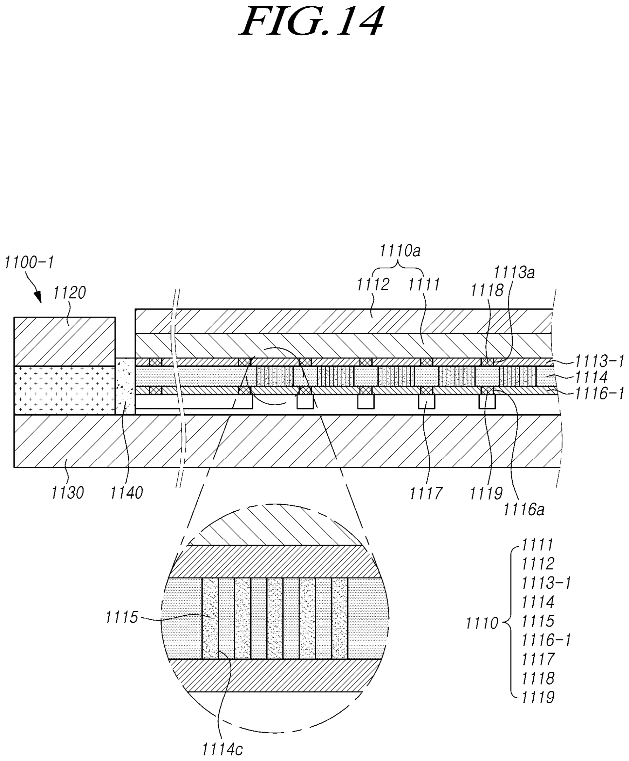

FIG. 14 is a cross-sectional view schematically illustrating a heat dissipation structure with enhanced adhesion in an electronic device according to an embodiment.

FIG. 14 is an exemplary view that simplifies the coupling relationship to easily describe the heat dissipation structure of the electronic device 1100-1 (e.g., the electronic device 101 of FIG. 1 or electronic device 200 of FIG. 2A), and the position of each component is not limited to what is illustrated. For example, the circuit board 1120 (e.g., the printed circuit board 224 of FIG. 4) or battery 1130 (e.g., the battery 250 of FIG. 4) may be disposed at various positions according to design in the inner space of the electronic device 1100-1.

Among the components of the schematic structure of the electronic device 1100-1 illustrated in FIG. 14, the same reference numerals are used for components that are substantially the same as the components of the electronic device 1100 illustrated in FIG. 12.

Referring to FIG. 14, the display assembly 1110 may include a first heat dissipation member 1113-1 having a plurality of first heat dissipation member holes 1113a formed therein. The first heat dissipation member 1113-1 of FIG. 14 may have a plurality of first heat dissipation member holes 1113a formed therein, unlike the first heat dissipation member 1113 of FIG. 12. The plurality of first heat dissipation member holes 1113a may be provided to be spaced apart from each other at predetermined intervals. Some of the plurality of first heat dissipation member holes 1113a may be formed at positions corresponding to the support portions in the flexible area 1114b of the support plate 1114.

According to an example, the display assembly 1110 may further include a first adhesive member 1118. The first adhesive member 1118 may be configured to fill the first heat dissipation member holes 1113a. One side of the first adhesive member 1118 may, e.g., be adhered to the flexible display 1110a (or display panel), but the disclosure is not limited thereto. The other side of the first adhesive member 1118 may, e.g., be adhered to the support plate 1114. The first adhesive member 1118 may enhance the adhesion between the flexible display 1110a (or display panel) and the first heat dissipation member 1113-1. The first adhesive member 1118 may enhance the adhesion between the first heat dissipation member 1113-1 and the support plate 1114. By forming the plurality of first heat dissipation member holes 1113a in the first heat dissipation member 1113-1 and filling the space with the first adhesive member 1118, it is possible to prevent delamination of the first heat dissipation member 1113-1 from the flexible display 1110a or support plate 1114 due to loss of adhesion. Further, by filling the first heat dissipation member holes 1113a rather than adding a separate layer for the first adhesive member, the adhesion of the first heat dissipation member 1113-1 may be enhanced while maintaining the thickness of the display assembly 1110.

According to an example, the display assembly 1110 may include a fourth heat dissipation member 1116-1 having a plurality of second heat dissipation member holes 1116a formed therein. The fourth heat dissipation member 1116-1 of FIG. 14 may have a plurality of second heat dissipation member holes 1116a formed therein, unlike the fourth heat dissipation member 1116 of FIG. 12. The plurality of second heat dissipation member holes 1116a may be provided to be spaced apart from each other at predetermined intervals. At least some of the plurality of second heat dissipation member holes 1116a may be formed at positions corresponding to the support portions in the flexible area 1114b of the support plate 1114.

According to an example, the display assembly 1110 may further include a second adhesive member 1119. The second adhesive member 1119 may be configured to fill the second heat dissipation member holes 1116a. One side of the second adhesive member 1119 may, e.g., be adhered to the support plate 1114. The other side of the second adhesive member 1119 may, e.g., be adhered to the support bar 1117. The second adhesive member 1119 may enhance the adhesion between the support plate 1114 and the support bar 1117. The second adhesive member 1119 may enhance the adhesion between the fourth heat dissipation member 1116-1 and the support plate 1114. By forming the plurality of second heat dissipation member holes 1116a in the fourth heat dissipation member 1116-1 and filling the space with the second adhesive member 1119, it is possible to prevent delamination of the fourth heat dissipation member 1116-1 from the support bar 1117 or separation of the support bar 1117 due to loss of adhesion. Further, by filling the second heat dissipation member holes 1116a rather than adding a separate layer for the second adhesive member, the adhesion of the fourth heat dissipation member 1116-1 may be enhanced while maintaining the thickness of the display assembly 1110.

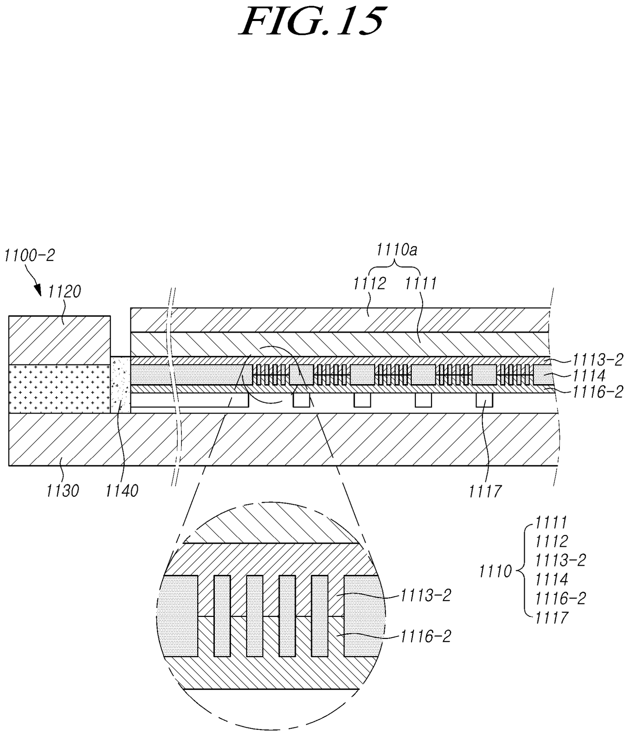

FIG. 15 is a cross-sectional view schematically illustrating a heat dissipation structure of an electronic device according to an embodiment.

FIG. 15 is an exemplary view that simplifies the coupling relationship to easily describe the heat dissipation structure of the electronic device 1100-2 (e.g., the electronic device 101 of FIG. 1 or electronic device 200 of FIG. 2A), and the position of each component is not limited to what is illustrated. For example, the circuit board 1120 (e.g., the printed circuit board 224 of FIG. 4) or battery 1130 (e.g., the battery 250 of FIG. 4) may be disposed at various positions according to design in the inner space of the electronic device 1100.

Among the components of the schematic structure of the electronic device 1100-2 illustrated in FIG. 15, the same reference numerals are used for components that are substantially the same as the components of the electronic device 1100 illustrated in FIG. 12.

Referring to FIG. 15, the electronic device 1100-2 according to an embodiment may omit the second heat dissipation member (e.g., the second heat dissipation member 1115 of FIG. 12) compared to the electronic device 1100 illustrated in FIG. 12. According to an example, at least one of a portion of the first heat dissipation member 1113-2 or a portion of the fourth heat dissipation member 1116-2 may be disposed in the space portion 1114c of the support plate 1114.

In a case where applying the first heat dissipation member 1113-2 on the upper side of the support plate 1114, at least a portion may be drawn into the space portion 1114c of the support plate 1114. The portion of the first heat dissipation member 1113-2 drawn into the space portion 1114c may replace the role of the second heat dissipation member 1115 of FIG. 12.

In a case where applying the fourth heat dissipation member 1116-2 on the lower side of the support plate 1114, at least a portion may be drawn into the space portion 1114c of the support plate 1114. The portion of the fourth heat dissipation member 1116-2 drawn into the space portion 1114c may replace the role of the second heat dissipation member 1115 of FIG. 12.

According to an example, the first heat dissipation member 1113-2 and the fourth heat dissipation member 1116-2 may contact each other in the space portion 1114c of the support plate 1114. For example, the first heat dissipation member 1113-2 and the fourth heat dissipation member 1116-2 may have predetermined adhesion. As the first heat dissipation member 1113-2 and the fourth heat dissipation member 1116-2 contact each other in the space portion 1114c, adhesion between the first heat dissipation member 1113-2 and the fourth heat dissipation member 1116-2 may be enhanced. As the first heat dissipation member 1113-2 and the fourth heat dissipation member 1116-2 are adhered in the space portion 1114c, delamination of each of the first heat dissipation member 1113-2 and the fourth heat dissipation member 1116-2 from the support plate 1114 may be prevented.

Similarly, the electronic device 1100-2 illustrated in FIG. 15 may form heat dissipation member holes in at least one of the first heat dissipation member 1113-2 or the fourth heat dissipation member 1116-2 and then fill them with adhesive members to enhance adhesion, as illustrated in FIG. 14. For example, the first heat dissipation member 1113-2 of FIG. 15 may also include first heat dissipation member holes and may fill the first heat dissipation member holes with the first adhesive member as described with reference to FIG. 14. For example, the fourth heat dissipation member 1116-2 of FIG. 15 may also include second heat dissipation member holes and may fill the second heat dissipation member holes with the second adhesive member as described with reference to FIG. 14.

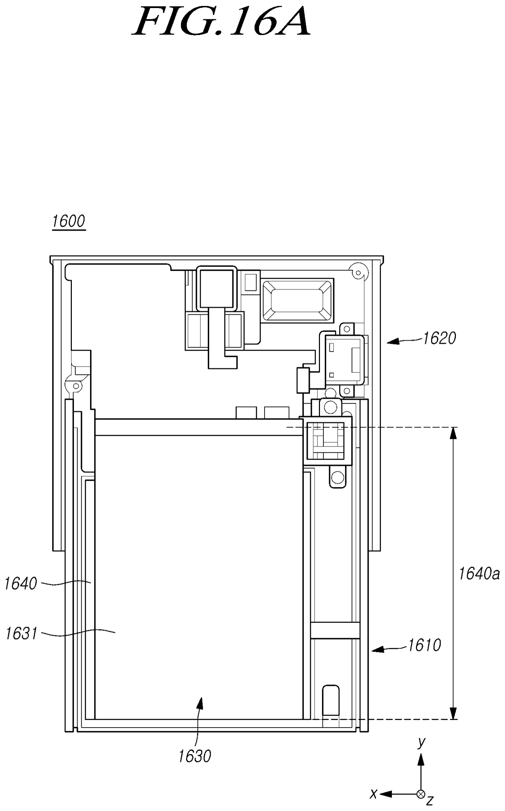

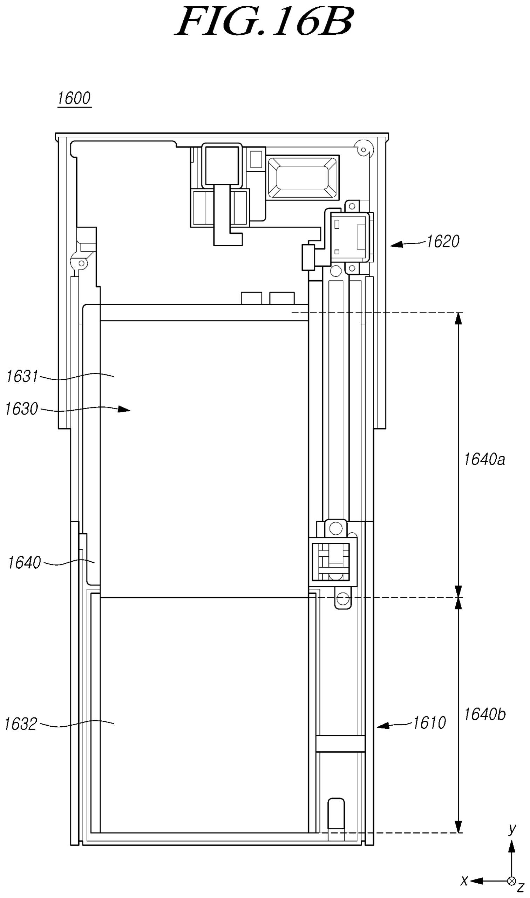

FIGS. 16A and 16B are views of an electronic device according to an embodiment, with some components omitted.

FIGS. 16A and 16B are plan views illustrating the electronic device 1600 (e.g., the electronic device 101 of FIG. 1, the electronic device 200 of FIG. 2A, the electronic device 600 of FIG. 8, or the electronic device 1100 of FIG. 12) viewed from above. To describe the planar shape of a heat dissipation member (e.g., the first heat dissipation member 1630), components such as a flexible display (e.g., the display 230 of FIG. 2A) disposed on the upper side of the first heat dissipation member 1630 (e.g., the first heat dissipation member 613 of FIG. 8 or the first heat dissipation member 1113 of FIG. 12) are omitted in FIGS. 16A and 16B.

FIG. 16A is a plan view in a first state (e.g., contracted state, closed state, slide-in state, or retracted state), and FIG. 16B is a plan view in a second state (e.g., extended state, open state, or slide-out state) where the second housing 1620 (e.g., the second housing 220 of FIG. 2A) is slid and extended with respect to the first housing 1610 (e.g., the first housing 210 of FIG. 2A).

The following description focuses primarily on the first heat dissipation member 1630 disposed on the upper side of the support plate 1640 (e.g., the support plate 615 of FIG. 8 or the support plate 1114 of FIG. 12), but the following features may similarly be applied to a fourth heat dissipation member (e.g., the fourth heat dissipation member 1116of FIG. 12) disposed on the lower side of the support plate 1640.

Referring to FIGS. 16A and 16B, the first heat dissipation member 1630 may be disposed above the support plate 1640. The first heat dissipation member 1630 may be disposed across the fixed area 1640a of the support plate 1640 and the flexible area 1640b of the support plate 1640. A portion of the first heat dissipation member 1630 may contact an upper surface of the fixed area 1640a of the support plate 1640. Another portion of the first heat dissipation member 1630 may contact an upper surface of the flexible area 1640b of the support plate 1640.

According to an example, the first heat dissipation member 1630 may include a first portion 1631 and a second portion 1632. The first portion 1631 may be a portion corresponding to the fixed area 1640a of the support plate 1640. The second portion 1632 may be a portion corresponding to the flexible area 1640b of the support plate 1640. The first portion 1631 and the second portion 1632 may have the same average width as illustrated. The width may refer to a length in a direction (e.g., x-axis direction) perpendicular to a direction in which the second housing 1620 slides (e.g., y-axis direction).

In the first state of the electronic device 1600, the first portion 1631 of the first heat dissipation member 1630 may face a front surface of the electronic device 1600 (e.g., -z direction). For example, in a case where the electronic device 1600 is in the first state, the first portion 1631 of the first heat dissipation member 1630 may dissipate heat to the outside.

In the second state of the electronic device 1600, the first portion 1631 and the second portion 1632 of the first heat dissipation member 1630 may face the front surface of the electronic device 1600 (e.g., -z direction). For example, in a case where the electronic device 1600 is in the second state, the first portion 1631 and the second portion 1632 of the first heat dissipation member 1630 may dissipate heat to the outside. In the second state, the area of the first heat dissipation member 1630 that may dissipate heat to the outside increases, thereby enhancing heat dissipation efficiency. Comparing FIGS. 16A and 16B, it may be identified that the area for heat dissipation in the second state is larger than the area for heat dissipation in the first state.

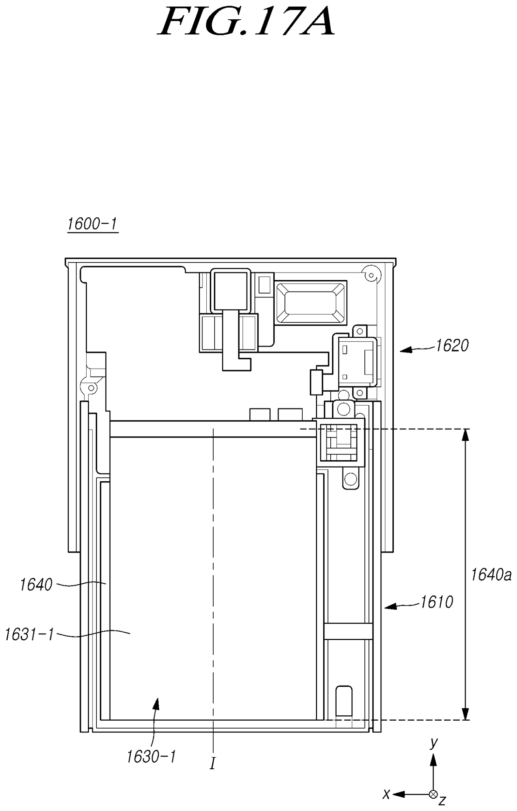

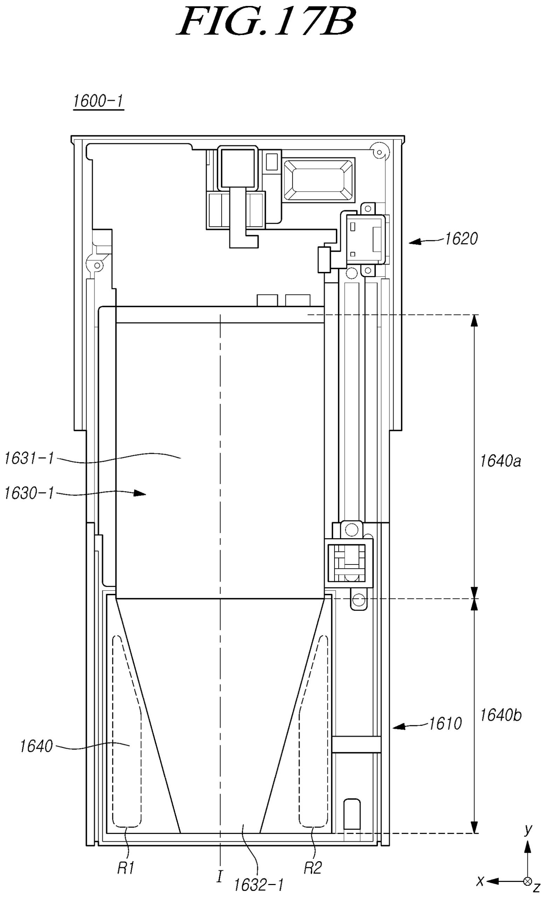

FIGS. 17A and 17B are plan views of an electronic device according to another embodiment, with some components omitted.

FIGS. 17A and 17B are plan views illustrating the electronic device 1600-1 (e.g., the electronic device 101 of FIG. 1, the electronic device 200 of FIG. 2A, the electronic device 600 of FIG. 8, or the electronic device 1100 of FIG. 12) viewed from above. To describe the planar shape of a heat dissipation member (e.g., the first heat dissipation member 1630-1), components such as a flexible display (e.g., the display 230 of FIG. 2A) disposed on the upper side of the first heat dissipation member 1630-1 (e.g., the first heat dissipation member 613 of FIG. 8 or the first heat dissipation member 1113 of FIG. 12) are omitted in FIGS. 17A and 17B.

FIG. 17A is a plan view in a first state (e.g., contracted state, closed state, slide-in state, or retracted state), and FIG. 17B is a plan view in a second state (e.g., extended state, open state, or slide-out state) where the second housing 1620 (e.g., the second housing 220 of FIG. 2A) is slid and extended with respect to the first housing 1610 (e.g., the first housing 210 of FIG. 2A).

FIGS. 17A and 17B illustrate an embodiment where the first heat dissipation member 1630-1 is partially modified from the embodiment of FIGS. 16A and 16B. The following description focuses primarily on the modified portions from the embodiment of FIGS. 16A and 16B, and descriptions of overlapping portions are omitted.

The following description focuses primarily on the first heat dissipation member 1630-1 disposed on the upper side of the support plate 1640 (e.g., the support plate 615 of FIG. 8 or the support plate 1114 of FIG. 12), but the following features may similarly be applied to a fourth heat dissipation member (e.g., the fourth heat dissipation member 1116 of FIG. 12) disposed on the lower side of the support plate 1640.

Referring to FIGS. 17A and 17B, the first heat dissipation member 1630-1 may include a first portion 1631-1, which is a portion corresponding to the fixed area 1640a of the support plate 1640, and a second portion 1632-1, which is a portion corresponding to the flexible area 1640b of the support plate 1640.

According to an example, the first portion 1631-1 may have the same shape as the first portion 1631 of FIG. 16A, but the disclosure is not limited thereto.

According to an example, the second portion 1632-1 may have a different average width from the first portion 1631-1. The average width of the second portion 1632-1 may be smaller than the average width of the first portion 1631-1. The second portion 1632-1 may extend, e.g., from the first portion 1631-1. The second portion 1632-1 may extend to gradually decrease in width away from the first portion 1631-1 as illustrated. However, without limitations thereto, the second portion 1632-1 may extend to stepwise decrease in width away from the first portion 1631-1 unless illustrated. The second portion 1632-1 may extend from the first portion 1631-1 while maintaining a width smaller than the first portion 1631-1, unlike illustrated.

The second portion 1632-1 may be designed to avoid two opposite side edges with respect to the center line I. For example, the second portion 1632-1 may be disposed to form symmetry with respect to the center line I. The center line I may refer to an imaginary line extending in the sliding direction of the second housing 1620 to divide the support plate 1640 in half. The center line I may extend, e.g., along the y-axis direction. In the portion that is bent (or rolled) according to the sliding movement of the second housing 1620, significant bending stress may be generated as it approaches two opposite side edge portions R1, R2 with respect to the center line I. In a case where large bending stress is generated, driving resistance increases, and accordingly, a large load may be applied to a driving device for driving the second housing 1620. By configuring the first heat dissipation member 1630-1 to avoid two opposite side edge portions R1, R2 where large bending stress is generated as illustrated, driving resistance may be mitigated. Further, manufacturing costs may be reduced by reducing the size of the heat dissipation member.

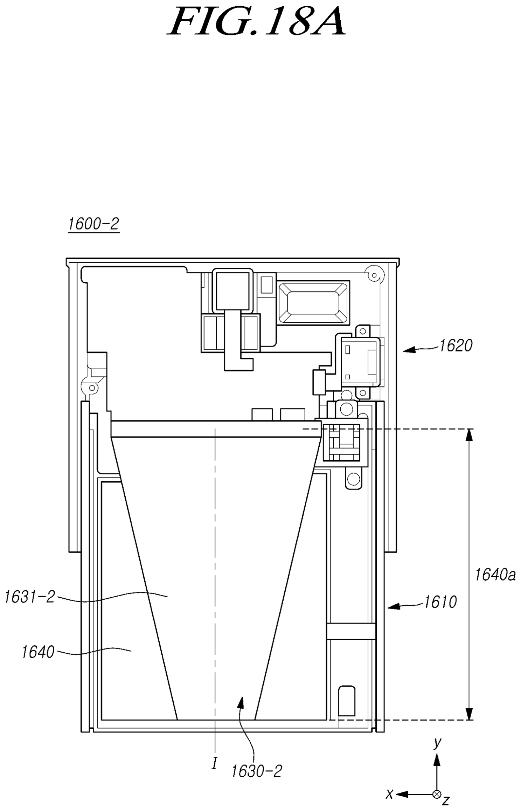

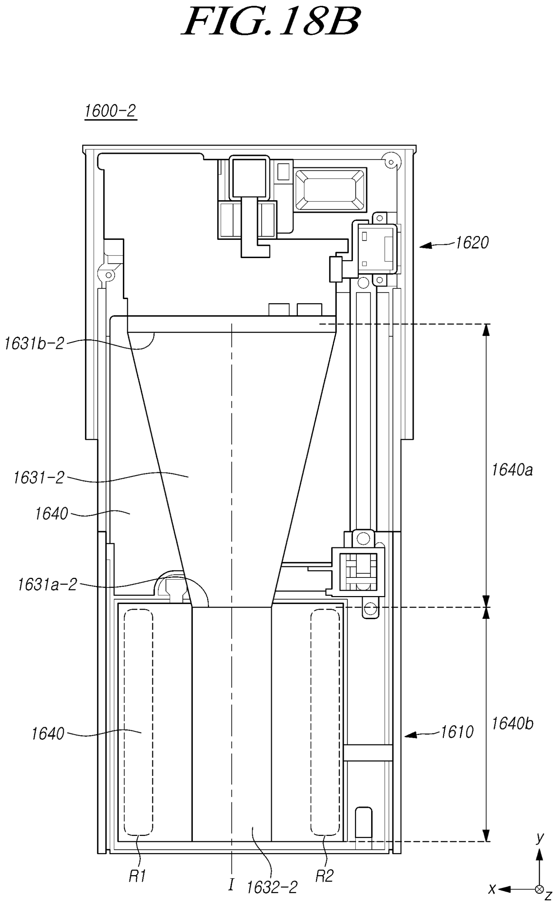

FIGS. 18A and 18B are plan views of an electronic device according to another embodiment, with some components omitted.

FIGS. 18A and 18B are plan views illustrating the electronic device 1600-2 (e.g., the electronic device 101 of FIG. 1, the electronic device 200 of FIG. 2A, the electronic device 600 of FIG. 8, or the electronic device 1100 of FIG. 12) viewed from above. To describe the planar shape of a heat dissipation member (e.g., the first heat dissipation member 1630-2), components such as a flexible display (e.g., the display 230 of FIG. 2A) disposed on the upper side of the first heat dissipation member 1630-2 (e.g., the first heat dissipation member 613 of FIG. 8 or the first heat dissipation member 1113 of FIG. 12) are omitted in FIGS. 18A and 18B.

FIG. 18A is a plan view in a first state (e.g., contracted state, closed state, slide-in state, or retracted state), and FIG. 18B is a plan view in a second state (e.g., extended state, open state, or slide-out state) where the second housing 1620 is slid and extended with respect to the first housing 1610.

FIGS. 18A and 18B illustrate an embodiment where the first heat dissipation member 1630-2 is partially modified from the embodiment of FIGS. 16A and 16B. The following description focuses primarily on the modified portions from the embodiment of FIGS. 16A and 16B, and descriptions of overlapping portions are omitted.

The following description focuses primarily on the first heat dissipation member 1630-2 disposed on the upper side of the support plate 1640 (e.g., the support plate 615 of FIG. 8 or the support plate 1114 of FIG. 12), but the following features may similarly be applied to a fourth heat dissipation member (e.g., the fourth heat dissipation member 1116 of FIG. 12) disposed on the lower side of the support plate 1640.

Referring to FIGS. 18A and 18B, the first heat dissipation member 1630-2 may include a first portion 1631-2, which is a portion corresponding to the fixed area 1640a of the support plate 1640, and a second portion 1632-2, which is a portion corresponding to the flexible area 1640b of the support plate 1640.

According to an example, the first portion 1631-2 may be configured so that the width of the first edge 1631a-2 contacting the second portion 1632-2 is smaller than the width of the second edge 1631b-2 positioned opposite to the first edge 1631a-2. The first portion 1631-2 may be configured to gradually decrease in width as it approaches the second portion 1632-2, as illustrated. However, without limitations thereto, the first portion may be configured to stepwise (or to be stepped) decrease in width as it approaches the second portion 1632-2, unlike illustrated. By configuring the first portion 1631-2 with differential widths, the size of the first heat dissipation member 1630-2 may be reduced, thereby reducing manufacturing costs.

According to an example, the first portion may be disposed symmetrically with respect to the center line I. The center line I may refer to an imaginary line extending in the sliding direction of the second housing 1620 to divide the support plate 1640 in half. The center line I may extend, e.g., along the y-axis direction.

According to an example, the second portion 1632-2 may have a different average width from the first portion 1631-2. The average width of the second portion 1632-2 may be smaller than the average width of the first portion 1631-2. The second portion 1632-2 may extend, e.g., from the first portion 1631-2. The second portion 1632-2 may extend from the first portion 1631-2 while maintaining the same width, as illustrated.

According to an example, the second portion 1632-2 may be designed to avoid two opposite side edge portions R1, R2 with respect to the center line I. For example, the second portion 1632-2 may be disposed to form symmetry with respect to the center line I. By disposing the second portion 1632-2 around the center line I while avoiding edge portions where large bending stress is generated, driving resistance may be mitigated. Further, manufacturing costs may be reduced by reducing the size of the heat dissipation member.

According to another embodiment, an electronic device may comprise a first housing 210, a second housing 220 coupled to the first housing 210 to be movable with respect to the first housing 210, at least one heat generating element 620, 630, 1120, 1130 disposed in the first housing 210 or the second housing 220, a display assembly 610, 1110 disposed across the first housing 210 and the second housing 220 and configured so that at least a portion thereof is bendable, the display assembly comprising a display panel 611, 1111 including a flat area and a flexible area, a support plate 615, 1114 disposed under the display panel 611, 1111 and having a plurality of space portions formed in a portion corresponding to the flexible area, a first heat dissipation member 613, 1113 disposed between the display panel 611, 1111 and the support plate 615, 1114, and a second heat dissipation member 617, 1115 filling the plurality of space portions, and a third heat dissipation member 640, 1140 disposed between at least one of the first heat dissipation member 613, 1113 and the support plate 615, 1114 and the at least one heat generating element 620, 630, 1120, 1130.

According to an embodiment, the second heat dissipation member 617, 1115 may be configured to contact the first heat dissipation member 613, 1113.

According to an embodiment, the first heat dissipation member 613, 1113 may include a plurality of first heat dissipation member holes 6131, 1113a penetrating vertically therethrough. The display assembly 610, 1110 may include a first adhesive member 619, 1118 filling the first heat dissipation member holes 6131, 1113a.

According to an embodiment, the first adhesive member 619, 1118 may be configured so that one side thereof is adhered to the display panel 611, 1111 and another side thereof is adhered to the support plate 615, 1114.

According to an embodiment, the first heat dissipation member 613, 1113 may be configured so that an average width of a portion corresponding to a planar area of the display panel 611, 1111 is wider than an average width of a portion corresponding to a flexible area of the display panel 611, 1111.

According to an embodiment, the at least one heat generating element 620, 630, 1120, 1130 may include at least one of a printed circuit board or a battery.

According to an embodiment, a thermal conductivity of the first heat dissipation member 613, 1113 may be configured to be larger than a thermal conductivity of the support plate 615, 1114.

According to an embodiment, the display assembly 1110 may further include a fourth heat dissipation member 1116 disposed under the support plate 1114 and positioned to contact the second heat dissipation member 1115.

According to an embodiment, the first heat dissipation member 1113 may be configured to have a lower modulus than the fourth heat dissipation member 1116.

According to an embodiment, a thickness of the first heat dissipation member 1113 may be configured to be thicker than a thickness of the fourth heat dissipation member 1116.

According to an embodiment, the fourth heat dissipation member 1116 may include a plurality of second heat dissipation member holes 1116a penetrating vertically therethrough. The display assembly 1110 may include a second adhesive member 1119 filling the second heat dissipation member holes 1116a.

According to an embodiment, the display assembly 1110 may further include a plurality of support bars 1117 configured to be disposed to be spaced apart from each other at predetermined intervals under a portion of the support plate 1114 corresponding to the flexible area of the display panel 1111. The second adhesive member 1119 may be configured so that one side thereof is adhered to the support plate 1114 and another side thereof is adhered to the support bar 1117.

According to an embodiment, the fourth heat dissipation member 1116 may be configured so that an average width of a portion corresponding to a planar area of the display panel 1111 is wider than an average width of a portion corresponding to a flexible area of the display panel 1111.

According to an embodiment, a width of the second heat dissipation member 617, 1115 may be a length in a direction perpendicular to a direction in which the second housing 220 slides.

According to an embodiment, a display assembly 610, 1110 configured so that at least a portion thereof is bendable may comprise a display panel 611, 1111 including a flat area and a flexible area, a support plate 615, 1114 disposed under the display panel 611, 1111 and having a plurality of space portions formed in a portion corresponding to the flexible area, a first heat dissipation member 613, 1113 disposed between the display panel 611, 1111 and the support plate 615, 1114, and a second heat dissipation member 617, 1115 filling the plurality of space portions of the support plate 615, 1114.

According to an embodiment, the first heat dissipation member 613, 1113 may include a plurality of first heat dissipation member holes 6131, 1113a penetrating vertically therethrough. The display assembly 610, 1110 may further include a first adhesive member 619, 1118 filling the first heat dissipation member holes 6131, 1113a.

According to an embodiment, the display assembly 610, 1110 may further comprise a fourth heat dissipation member 1116 disposed under the support plate 1114 and positioned to contact the first heat dissipation member 1113.

According to an embodiment, the first heat dissipation member 1113 may be configured to have a lower modulus than the fourth heat dissipation member 1116.

According to an embodiment, a thickness of the first heat dissipation member 1113 may be configured to be thicker than a thickness of the fourth heat dissipation member 1116.

According to an embodiment, the first heat dissipation member 1113 or the second heat dissipation member 1115 may be configured so that an average width of a portion corresponding to a planar area of the display panel 1111 is wider than an average width of a portion corresponding to a flexible area of the display panel 1111.

The terms as used herein are provided merely to describe some embodiments thereof, but are not intended to limit the disclosure. As used herein, the singular forms "a," "an," and "the" are intended to include the plural forms as well, unless the context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, the term 'and/or' should be understood as encompassing any and all possible combinations by one or more of the enumerated items. As used herein, the terms "include," "have," and "comprise" are used merely to designate the presence of the feature, component, part, or a combination thereof described herein, but use of the term does not exclude the likelihood of presence or adding one or more other features, components, parts, or combinations thereof. As used herein, the terms "first" and "second" may modify various components regardless of importance and/or order and are used to distinguish a component from another without limiting the components.

As used herein, the terms "configured to" may be interchangeably used with the terms "suitable for," "having the capacity to," "designed to," "adapted to," "made to," or "capable of" depending on circumstances. The term "configured to" does not essentially mean "specifically designed in hardware to." Rather, the term "configured to" may mean that a device can perform an operation together with another device or parts. For example, a 'device configured (or set) to perform A, B, and C' may be a dedicated device to perform the corresponding operation or may mean a general-purpose device capable of various operations including the corresponding operation.

Meanwhile, the terms "upper side", "lower side", and "front and rear directions" used in the disclosure are defined with respect to the drawings, and the shape and position of each component are not limited by these terms.

In the disclosure, the above-described description has been made mainly of specific embodiments, but the disclosure is not limited to such specific embodiments, but should rather be appreciated as covering all various modifications, equivalents, and/or substitutes of various embodiments.

## Claims

1. An electronic device, comprising:
a first housing (210);
a second housing (220) coupled to the first housing (210) to be movable with respect to the first housing (210);
at least one heat generating element (620, 630, 1120, 1130) in the first housing (210) or the second housing (220);
a display assembly (610, 1110) disposed across the first housing (210) and the second housing (220) and configured so that at least a portion of the display assembly is bendable, the display assembly comprising a display panel (611, 1111), a support plate (615, 1114) disposed under the display panel (611, 1111) and having a plurality of space portions, a first heat dissipation member (613, 1113) between the display panel (611, 1111) and the support plate (615, 1114), and a second heat dissipation member (617, 1115) filling the plurality of space portions; and
a third heat dissipation member (640, 1140) between at least one of the first heat dissipation member (613, 1113) and the support plate (615, 1114) and the at least one heat generating element (620, 630, 1120, 1130).

2. The electronic device of claim 1, wherein the second heat dissipation member (617, 1115) is configured to contact the first heat dissipation member (613, 1113).

3. The electronic device of claim 1 or 2, wherein the first heat dissipation member (613, 1113) includes a plurality of first heat dissipation member holes (6131, 1113a) penetrating vertically therethrough,
wherein the display assembly (610, 1110) includes a first adhesive member (619, 1118) filling the first heat dissipation member holes (6131, 1113a), and
wherein the first adhesive member (619, 1118) is configured so that one side of the first adhesive member (619, 1118) is adhered to the display panel (611, 1111) and another side of the first adhesive member (619, 1118) is adhered to the support plate (615, 1114).

4. The electronic device of any one of claims 1 to 3, wherein the first heat dissipation member (613, 1113) is configured so that an average width of a portion corresponding to a planar area of the display panel (611, 1111) is wider than an average width of a portion corresponding to a flexible area of the display panel (611, 1111).

5. The electronic device of any one of claims 1 to 4, wherein a thermal conductivity of the first heat dissipation member (613, 1113) is configured to be larger than a thermal conductivity of the support plate (615, 1114).

6. The electronic device of any one of claims 1 to 5, wherein the display assembly (1110) further includes a fourth heat dissipation member (1116) disposed under the support plate (1114) and positioned to contact the second heat dissipation member (1115).

7. The electronic device of claim 6, wherein the first heat dissipation member (1113) is configured to have a lower modulus than the fourth heat dissipation member (1116).

8. The electronic device of claim 6 or 7, wherein a thickness of the first heat dissipation member (1113) is configured to be thicker than a thickness of the fourth heat dissipation member (1116).

9. The electronic device of any one of claims 6 to 8, wherein the fourth heat dissipation member (1116) includes a plurality of second heat dissipation member holes (1116a) penetrating vertically therethrough, and
wherein the display assembly (1110) includes a second adhesive member (1119) filling the second heat dissipation member holes (1116a).

10. The electronic device of any one of claims 6 to 9, wherein the fourth heat dissipation member (1116) is configured so that an average width of a portion corresponding to a planar area of the display panel (1111) is wider than an average width of a portion corresponding to a flexible area of the display panel (1111), and
wherein a width of the second heat dissipation member (617, 1115) is a length in a direction perpendicular to a direction in which the second housing (220) slides.

11. A display assembly (610, 1110) configured so that at least a portion thereof is bendable, the display assembly comprising:
a display panel (611, 1111);
a support plate (615, 1114) disposed under the display panel (611, 1111) and having a plurality of space portions formed therein;
a first heat dissipation member (613, 1113) between the display panel (611, 1111) and the support plate (615, 1114); and
a second heat dissipation member (617, 1115) filling the plurality of space portions of the support plate (615, 1114).

12. The display assembly of claim 11, wherein the first heat dissipation member (613, 1113) includes a plurality of first heat dissipation member holes (6131, 1113a) penetrating vertically therethrough, and
wherein the display assembly (610, 1110) further includes a first adhesive member (619, 1118) filling the first heat dissipation member holes (6131, 1113a).

13. The display assembly of claim 11 or 12, further comprising a fourth heat dissipation member (1116) disposed under the support plate (1114) and positioned to contact the first heat dissipation member (1113).

14. The display assembly of claim 13, wherein the first heat dissipation member (1113) is configured to have a lower modulus than the fourth heat dissipation member (1116).

15. The display assembly of claim 13 or 14, wherein a thickness of the first heat dissipation member (1113) is configured to be thicker than a thickness of the fourth heat dissipation member (1116).
